# EUROPEAN PATENT APPLICATION

(11) **EP 4 836 668 A1**
(43) Date of publication of application: **04.11.2026**
(21) Application number: 26173921.3
(22) Date of filing: 22.04.2026
(51) Int. Cl.: H10P 72/00, H10P 50/61

(54) **SUBSTRATE PROCESSING APPARATUS AND SUBSTRATE PROCESSING METHOD**

(30) Priority: 28.04.2025 JP 2025074557
(71) Applicant: SCREEN Holdings Co., Ltd., Kyoto-shi, Kyoto 602-8585 (JP)
(72) Inventor: NAKANO, Hiroki, Kyoto, 602-8585 (JP); WAKITA, Asuka, Kyoto, 602-8585 (JP); MORITA, Kosei, Kyoto, 602-8585 (JP)
(74) Representative: Kilian Kilian & Partner mbB

(57) **Abstract**

A substrate processing apparatus includes a nozzle that supplies a processing liquid for etching from above a substrate to the upper surface of the substrate to bring the liquid into contact with a processing membrane. A nozzle movement mechanism causes the nozzle to horizontally rock between central and peripheral edge portions of the substrate above the rotating substrate. A first electrode is electrically connected to the substrate. A second electrode is electrically connected to the processing liquid ejected from the nozzle. A power source applies a voltage between first and second electrodes under control of a controller. The processing liquid is continuously supplied from the rocking nozzle to the upper surface of the substrate above the substrate, and with the voltage applied between the first and second electrodes, a rotational frequency of the substrate is repeatedly switched between first and second different rotational frequencies in a predetermined rotational-frequency switching cycle.

## Description

### CROSS-REFERENCE TO RELATED APPLICATIONS

This application claims priority benefit of Japanese Patent Application No. JP2025-074557 filed in the Japan Patent Office on April 28, 2025, the entire disclosure of which is incorporated herein by reference.

### TECHNICAL FIELD

The present invention relates to a technique for performing etching on a substrate.

### BACKGROUND ART

A conventional process of manufacturing semiconductor substrates (hereinafter, simply referred to as "substrates") involves various types of processing that are performed on the substrates. For example, in the process of manufacturing a substrate, wet etching is performed on the substrate, in which an etchant is applied to the substrate to remove a membrane on the substrate. In the wet etching, it is known that the etch rate of the membrane becomes low within fine recessed portions such as trenches or holes provided in the substrate.

In view of this, Japanese Patent Application Laid-Open No. 2020-155614 (Document 1) proposes a technique for promptly allowing conductive components of a processing liquid to enter gaps in microstructures by supplying an etchant having conductivity to a substrate and applying a direct current of a certain magnitude between the substrate and the etchant adhering to the substrate. International Publication No. 2021/192502 (Document 2) proposes a technique for increasing an etch rate by applying an alternating voltage at a frequency of 0.1 kHz or 1 kHz to a pair of electrodes arranged to sandwich a substrate that is in contact with an etchant.

In the substrate etching process, there is demand for a further increase in the etch rate. In particular, ordinary etching methods require a further increase in the etch rate for etching of a membrane within fine recessed portions where the etch rate drops significantly.

### SUMMARY OF THE INVENTION

The present invention is intended for a substrate processing apparatus that performs etching on a substrate, and it is an object of the present invention to increase an etch rate.

Aspect 1 of the present invention is a substrate processing apparatus that performs etching on a substrate. The substrate processing apparatus includes a substrate holder that holds a substrate in a horizontal position, the substrate having an upper surface on which a processing membrane is provided, a substrate rotation mechanism that rotates the substrate holder about a central axis extending in an up-down direction, a nozzle that supplies a processing liquid for etching from above the substrate to the upper surface of the substrate to bring the processing liquid into contact with the processing membrane, a nozzle movement mechanism that causes the nozzle to horizontally rock between a central portion of the substrate and a peripheral edge portion of the substrate above the substrate that is being rotated, a first electrode that is electrically connected to the substrate, a second electrode that is electrically connected to the processing liquid ejected from the nozzle, a power source that provides an applied voltage between the first electrode and the second electrode, and a controller that controls the substrate rotation mechanism, the nozzle, and the power source. Under control of the controller, a rotational frequency of the substrate is repeatedly switched between a first rotational frequency and a second rotational frequency different from the first rotational frequency in a predetermined rotational-frequency switching cycle while the processing liquid is continuously supplied from the nozzle to the upper surface of the substrate, the nozzle rocking above the substate that is being rotated, and a voltage is applied between the first electrode and the second electrode.

According to the present invention, it is possible to increase the etch rate.

Aspect 2 of the present invention is the substrate processing apparatus according to Aspect 1, in which, under control of the controller, in parallel with switching of the rotational frequency of the substrate, a potential on a side wall surface that forms a recessed portion in a pattern on said substrate is repeatedly switched between a first potential and a second potential lower than the first potential by repeatedly switching the applied voltage between a first voltage and a second voltage different from the first voltage in a predetermined voltage switching cycle. The first potential is higher than or equal to 0V, and the second potential is lower than or equal to 0V.

Aspect 3 of the present invention is the substrate processing apparatus according to Aspect 2, in which the predetermined voltage switching cycle is more than or equal to 0.05 seconds.

Aspect 4 of the present invention is the substrate processing apparatus according to Aspect 2 (or according to Aspect 2 or 3), in which the predetermined rotational-frequency switching cycle is an integer multiple of the predetermined voltage switching cycle.

Aspect 5 of the present invention is the substrate processing apparatus according to Aspect 4, in which the predetermined rotational-frequency switching cycle is an even multiple of the predetermined voltage switching cycle.

Aspect 6 of the present invention is the substrate processing apparatus according to any one of Aspects 2 to 5, in which switching of the rotational frequency of the substrate is performed simultaneously with switching of the applied voltage under control of the controller.

Aspect 7 of the present invention is a substrate processing method of performing etching on a substrate. The substrate processing method includes a) holding a substrate in a horizontal position, the substrate having an upper surface on which a processing membrane is provided, b) continuously supplying a processing liquid for etching from a nozzle to the upper surface of the substrate, the nozzle rocking horizontally between a central portion of the substrate and a peripheral edge portion of the substrate above the substrate that is being rotated about a central axis extending in an up-down direction, c) in parallel with the operation b), repeatedly switching a rotational frequency of the substrate between a first rotational frequency and a second rotational frequency different from the first rotational frequency in a predetermined rotational-frequency switching cycle, and d) in parallel with the operation c), providing an applied voltage between the substrate and the processing liquid ejected from the nozzle and repeatedly switching a potential on a side wall surface between a first potential and a second potential lower than the first potential, the side wall surface forming a recessed portion in a pattern on the substrate, by repeatedly switching the applied voltage between a first voltage and a second voltage different from the first voltage in a predetermined voltage switching cycle. The first potential is higher than or equal to 0V, and the second potential is lower than or equal to 0V.

These and other objects, features, aspects and advantages of the present invention will become more apparent from the following detailed description of the present invention when taken in conjunction with the accompanying drawings.

### BRIEF DESCRIPTION OF DRAWINGS

Fig. 1 is a plan view of a substrate processing system.
Fig. 2 is a side view of a substrate processing apparatus according to a first embodiment.
Fig. 3 is a diagram showing a portion in the vicinity of one chuck pin in enlarged dimensions.
Fig. 4 is a sectional view showing part of a substrate in enlarged dimensions.
Fig. 5 is a flowchart showing a procedure for substrate processing.
Fig. 6 is a side view of the substrate processing apparatus.
Fig. 7 is a diagram illustrating switching of the rotational frequency of the substrate.
Fig. 8A is a diagram showing a waveform of an applied voltage.
Fig. 8B is a diagram showing a waveform of an applied voltage.
Fig. 9A is a sectional view showing part of the substrate in enlarged dimensions.
Fig. 9B is a sectional view showing part of the substrate in enlarged dimensions.
Fig. 9C is a sectional view showing part of the substrate in enlarged dimensions.
Fig. 9D is a sectional view showing part of the substrate in enlarged dimensions.
Fig. 10A is a sectional view showing part of the substrate in enlarged dimensions.
Fig. 10B is a sectional view showing part of the substrate in enlarged dimensions.
Fig. 10C is a sectional view showing part of the substrate in enlarged dimensions.
Fig. 10D is a sectional view showing part of the substrate in enlarged dimensions.
Fig. 11 is a diagram showing laboratory equipment.
Fig. 12 is a sectional view showing part of the substrate in enlarged dimensions.
Fig. 13 is a side view of another substrate processing apparatus.

### DESCRIPTION OF EMBODIMENTS

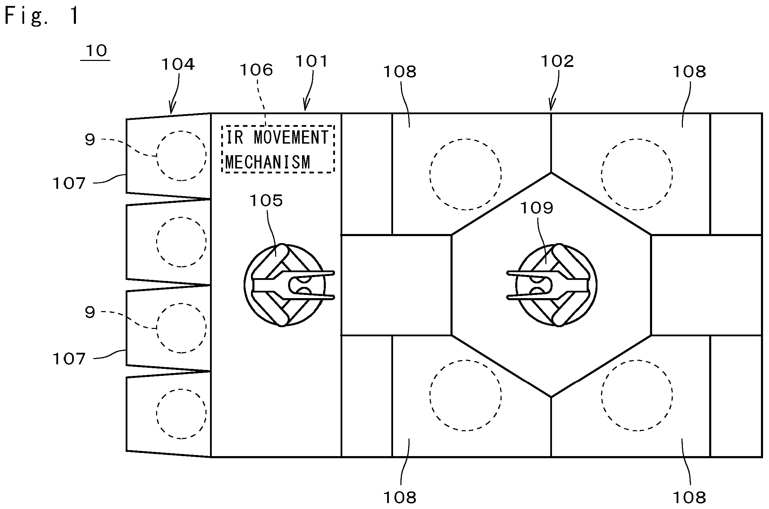

Fig. 1 is a diagrammatic plan view showing a layout of a substrate processing system 10. The substrate processing system 10 is a system that processes semiconductor substrates 9 (hereinafter, simply referred to as "substrates 9"). The substrate processing system 10 includes an indexer block 101 and a processing block 102 that is coupled to the indexer block 101.

The indexer block 101 includes a carrier holder 104, an indexer robot 105, and an IR movement mechanism 106. The carrier holder 104 holds a plurality of carriers 107 each capable of storing a plurality of substrates 9. The carriers 107 (e.g., FOUPs) are held by the carrier holder 104 while being aligned in a predetermined carrier alignment direction. The IR movement mechanism 106 moves the indexer robot 105 in the carrier alignment direction. The indexer robot 105 performs a transport-out operation of transporting the substrates 9 out of the carriers 107 and a transport-in operation of transporting the substrates 9 into the carriers 107 held by the carrier holder 104. The substrates 9 are transported in a horizontal position by the indexer robot 105.

The processing block 102 includes a plurality of (e.g., four or more) processing units 108 that process the substrates 9, and a center robot 109. The processing units 108 are arranged to surround the center robot 109 in plan view. The processing units 108 perform a variety of processing on the substrates 9. A substrate processing apparatus described later corresponds to one of the processing units 108. The center robot 109 performs a transport-in operation of transporting the substrates 9 into the processing units 108 and a transport-out operation of transporting the substrates 9 out of the processing units 108. The center robot 109 also transports the substrates 9 among the processing units 108. The substrates 9 are transported in a horizontal position by the center robot 109. The center robot 109 receives a substrate 9 from the indexer robot 105 or transfers a substrate 9 to the indexer robot 105.

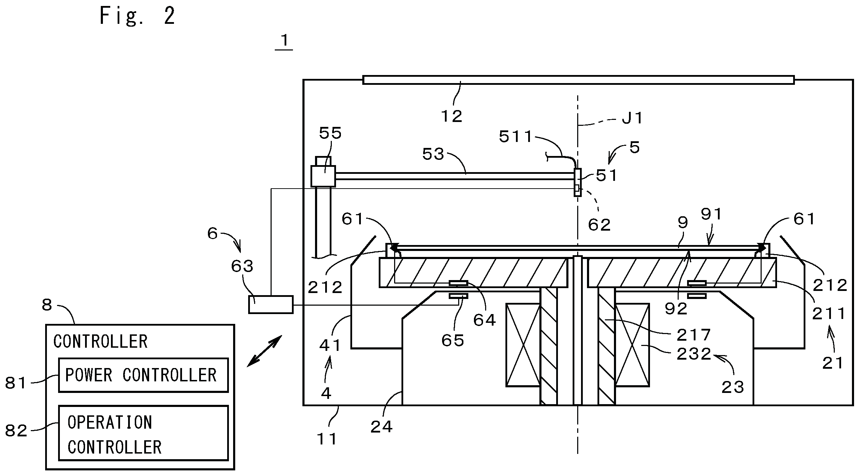

Fig. 2 is a side view showing a configuration of a substrate processing apparatus 1 according to a first embodiment of the present invention. The substrate processing apparatus 1 is a single-wafer apparatus that processes the substrates 9 one by one. The substrate processing apparatus 1 is an apparatus that performs etching on a processing membrane provided on an upper-side main surface of the substrate 9 (hereinafter, also referred to as the "upper surface 91"). Fig. 2 shows part of the configuration of the substrate processing apparatus 1 in cross section.

The substrate processing apparatus 1 includes a substrate holder 21, a substrate rotation mechanism 23, a cup part 4, a processing liquid supplier 5, a voltage application unit 6, a housing 11, and a controller 8. The substrate holder 21, the substrate rotation mechanism 23, the interrupter 3, the cup part 4, and so on are housed in the internal space of the housing 11. The canopy portion of the housing 11 is provided with an airflow former 12 that supplies a gas to the internal space to form an airflow flowing downward (so-called a downflow). As the airflow former 12, for example, a fan filter unit (FFU) is used. The controller 8 is arranged outside the housing 11 and controls the substrate holder 21, the substrate rotation mechanism 23, the processing liquid supplier 5, the voltage application unit 6, and so on.

The controller 8 is, for example, a general computer system that includes a CPU, ROM, RAM, a fixed disk, a display, an input device, a reader, a communicator, and a bus. A processor configured by the CPU or the like executes processing such as arithmetic operations in accordance with instructions such as programs stored in memory configured by the ROM, the RAM, the fixed disk, and so on. The controller 8 includes a power controller 81 and an operation controller 82 as functions realized by the processor. The power controller 81 controls a power source 63 (described later) of the voltage application unit 6. The operation controller 82 controls the processing liquid supplier 5, the substrate rotation mechanism 23, and so on. Note that the controller 8 may, for example, be a programmable logic controller (PLC) or a circuit board. The controller 8 may include a plurality of arbitrary configurations among the computer system, the PLC, the circuit board, and so on.

The substrate holder 21 and the substrate rotation mechanism 23 each serve as part of a spin chuck that holds and rotates an approximately disc-like substrate 9. The substrate holder 21 supports the substrate 9 in a horizontal position from the underside. The substrate holder 21 illustrated in Fig. 2 is a mechanical chuck that mechanically holds the substrate 9.

The substrate holder 21 includes a base part 211, a plurality of (e.g., four or six) chuck pins 212, and a shaft 217. The base part 211 is an approximately disc-like member centered on a central axis J1 extending in the up-down direction. The substrate 9 is arranged above and spaced from the base part 211. In other words, the base part 211 of the substrate holder 21 faces a lower-side main surface of the substrate 9 (hereinafter, also referred to as the "lower surface 92") in the up-down direction at a position spaced below from the lower surface 92. The diameter of the base part 211 is slightly greater than the diameter of the substrate 9. The shaft 217 is an approximately columnar or cylindrical member centered on the central axis J1. The shaft 217 extends in the up-down direction and is connected to a central portion of the lower surface of the base part 211.

In the substrate holder 21, the chuck pins 212 are aligned in an upright position in a circumferential direction centered on the central axis J1 (hereinafter, also simply referred to as the "circumferential direction") on an outer peripheral portion of the upper surface of the base part 211. The chuck pins 212 are located at approximately the same position in a radial direction centered on the central axis J1 (hereinafter, also simply referred to as the "radial direction"). In other words, the chuck pins 212 are located on approximately the same circle centered on the central axis J1. For example, the chuck pins 212 are arranged at approximately equiangular intervals in the circumferential direction. The chuck pins 212 hold the substrate 9 in contact with the peripheral edge portion of the substrate 9.

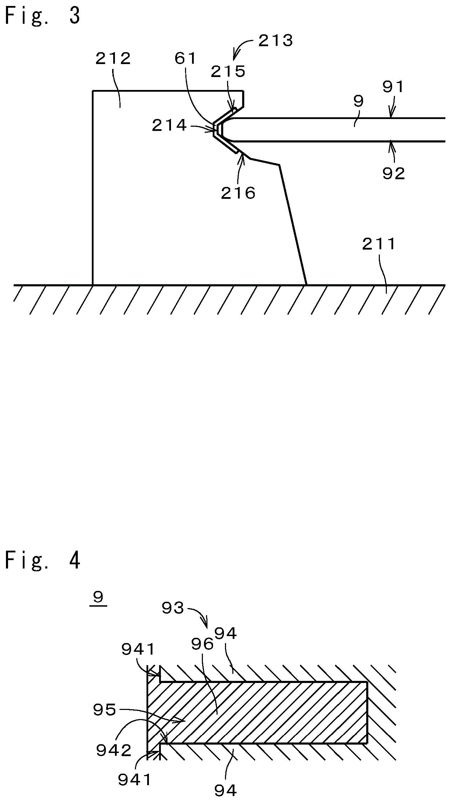

Fig. 3 shows a portion in the vicinity of one chuck pin 212 on the base part 211 in enlarged dimensions. The aforementioned multiple chuck pins 212 have approximately the same shape as the shape illustrated in Fig. 3. A radially inward side face in the upper portion of the chuck pin 212 (hereinafter, also referred to as the "upper inner side face 213) comes into direct contact with the peripheral edge portion of the substrate 9. A central portion 214 in the up-down direction of the upper inner side face 213 of the chuck pin 212 is recessed radially outward. In other words, the central portion 214 of the upper inner side face 213 of the chuck pin 212 is located radially outward of an upper portion 215 located above the central portion 214 and a lower portion 216 located below the central portion 214. When the substrate 9 is held by the substrate holder 21, the upper portion 215 of the upper inner side face 213 of the chuck pin 212 comes into direct contact with the peripheral edge portion of the upper surface 91 of the substrate 9, and the lower portion 216 of the upper inner side face 213 of the chuck pin 212 comes into direct contact with the peripheral edge portion of the lower surface 92 of the substrate 9.

As shown in Fig. 2, the substrate rotation mechanism 23 is arranged inside a cover part 24 that is arranged below the substrate holder 21. The cover part 24 is an approximately cylindrical covered member centered on the central axis J1. The upper surface of the cover part 24 and the lower surface of the base part 211 face each other in the up-down direction while being spaced from each other. There is a slight gap between the upper surface of the cover part 24 and the lower surface of the base part 211.

The substrate rotation mechanism 23 rotates the substrate 9 together with the substrate holder 21 about the central axis J1 extending approximately in parallel with the up-down direction. The substrate rotation mechanism 23 includes a motor 232. The motor 232 is an electric rotary motor that rotates the shaft 217 of the substrate holder 21. Note that the substrate rotation mechanism 23 may also be a motor having a different structure (e.g., a hollow motor).

The processing liquid supplier 5 supplies a processing liquid to the substrate 9. In the example shown in Fig. 2, the processing liquid supplier 5 includes a nozzle 51. The nozzle 51 is located above the substrate 9 and spaced from the upper surface 91 of the substrate 9. The nozzle 51 is capable of ejecting a processing liquid toward the upper surface 91 of the substrate 9. The processing liquid ejected from the nozzle 51 comes into contact with a processing membrane provided on the upper surface 91 of the substrate 9.

The nozzle 51 is supported above the substrate 9 by an arm 53 extending approximately horizontally. The nozzle 51 is an approximately cylindrical tube-like member extending approximately in parallel with the up-down direction. The end of the arm 53 on the side opposite the nozzle 51 is connected to a nozzle movement mechanism 55. The nozzle movement mechanism 55 horizontally moves the nozzle 51 by rotating the arm 53 in the horizontal direction. For example, the nozzle 51 is movable between a position above the substrate 9 and a retracted position that is located radially outward of the peripheral edge of the substrate 9. The nozzle movement mechanism 55 also moves the nozzle 51 up and down by moving the arm 53 in the up-down direction. The nozzle movement mechanism 55 is, for example, configured by a combination of a ball screw and an electric rotary motor. The nozzle movement mechanism 55 may also be an electric rotary motor, an electric linear motor, an air cylinder, or the like.

The processing liquid supplied from the nozzle 51 toward the upper surface 91 of the substrate 9 is, for example, a liquid for etching (i.e., an etching liquid) used to etch the processing membrane provided on the upper surface 91 of the substrate 9. The processing liquid generally has conductivity. Examples of the etching liquid include etchants such as hydrogen peroxide (H₂O₂), hydrofluoric acid (HF), nitric acid (HNO₃), ammonia (NH₃), tetramethylammonium hydroxide (TMAH), and tetrabutylammonium hydroxide (TBAH).

The nozzle 51 is also capable of ejecting a processing liquid used for rinse processing (i.e., a rinsing liquid) performed on the upper surface 91 of the substrate 9. As the rinsing liquid, deionized water (DIW) or the like may be used. The nozzle 51 may also be configured to be capable of ejecting processing liquids other than an etching liquid and a rinsing liquid and/or inert gases or the like such as a nitrogen (N₂) gas.

The cup part 4 includes a cup 41 and a cup elevating mechanism, which is not shown. The cup 41 is an annular member centered on the central axis J1. The cup 41 is arranged along the entire circumferences of the substrate 9 and the substrate holder 21 and covers the sides and bottoms of the substrate 9 and the substrate holder 21. The cup 41 is a liquid-receiving container that receives a liquid such as the processing liquid that is scattered from the rotating substrate 9 to the surroundings. The inner surface of the cup 41 is formed of, for example, a water-repellent material. The cup 41 remains stationary in the circumferential direction, irrespective of whether the substrate 9 is rotating or remains stationary. The bottom of the cup 41 is provided with a drain port (not shown) through which the processing liquid or the like received by the cup 41 is discharged to the outside of the housing 11.

The aforementioned cup elevating mechanism moves the cup 41 relative to the substrate holder 21 in the up-down direction. The cup elevating mechanism is, for example, an electric linear motor, an air cylinder, or a combination of a ball screw and an electric rotary motor, any of which is connected to the cup 41. The cup elevating mechanism is capable of moving the cup 41 in the up-down direction between a processing position that is a position located around the substrate 9 shown in Fig. 2 and a retracted position that is located below the processing position.

The cup part 4 may include a plurality of cups 41 that are stacked one above another in the radial direction. In the case where the cup part 4 includes the multiple cups 41, the cups 41 are movable independently of one another in the up-down direction. Depending on the type of the processing liquid scattered from the substrate 9, the multiple cups 41 are switched and used to receive the processing liquid.

The voltage application unit 6 includes first electrodes 61, a second electrode 62, the power source 63, a first transmitter 64, and a second transmitter 65. Each first electrode 61 is provided on each chuck pin 212 of the substrate holder 21. Specifically, as shown in Fig. 3, the first electrodes 61 are approximately plate-like conductive members provided on the upper inner side faces 213 of the chuck pins 212. The radially inner surfaces of the first electrodes 61 are not covered with the chuck pins 212 and exposed from the upper inner side faces 213 of the chuck pins 212.

The first electrodes 51 are provided across the upper portions 215, the central portions 214, and the lower portions 216 of the upper inner side faces 213 of the chuck pins 212. The first electrodes 61 are electrically connected to the substrate 9 in direct contact with the peripheral edge portion of the substrate 9. In the example shown in Fig. 3, the first electrodes 61 come into direct contact with both of the upper surface 91 and the lower surface 92 of the substrate 9 on the peripheral edge portion of the substrate 9.

The first electrodes 61 provided respectively on the chuck pins 212 are formed of a material with chemical resistance and high conductivity. Each first electrode 61 is formed of, for example, platinum (Pt) or glassy carbon (GC). Note that the shape, material, and so on of each first electrode 61 may be changed in various ways. The surface of a portion of each chuck pin 212 other than the portions where the first electrodes 61 are provided is formed of, for example, an insulator. This surface may also be formed of a conductor.

The second electrode 62 is electrically connected to the processing liquid ejected from the nozzle 51. In the example shown in Fig. 2, the second electrode 62 is provided inside the nozzle 51 and comes into direct contact with the processing liquid flowing through a flow path inside the nozzle 51 so as to be electrically connected to the processing liquid. Thus, before the processing liquid is ejected from the nozzle 51, the second electrode 62 is electrically connected to the processing liquid that is ejected from the nozzle 51. The second electrode 62 is formed of a material with high chemical resistance and high conductivity. For example, the second electrode 62 is formed of platinum (Pt) or glassy carbon (GC). Note that the material, arrangement, and so on of the second electrode 62 may be changed in various ways.

The second electrode 62 does not necessarily have to be provided inside the nozzle 51. For example, in the case where the nozzle 51 is formed of a highly conductive material such as glassy carbon, the second electrode 62 may be arranged so as to come into direct contact with the surface or the like of the nozzle 51. This allows the second electrode 62 to be electrically connected via the nozzle 51 to the processing liquid ejected from the nozzle 51 before the processing liquid is ejected from the nozzle 51.

Alternatively, in the case where piping 511 is a conductive tube such as an anti-static (AS) tube, the second electrode 62 may be arranged so as to come into direct contact with the surface or the like of the piping 511. This allows the second electrode 62 to be electrically connected via the piping 511 to the processing liquid ejected from the nozzle 51 before the processing liquid is ejected from the nozzle 51. The materials or the like of the nozzle 51 and the piping 511 may be changed in various ways.

Note that, in the case where the nozzle 51 and the piping 511 are conductors, for example, the second electrode 62 may be electrically connected to at least one of the nozzle 51 and the piping 511. As another alternative, in the case where the nozzle 51 is a conductor, the nozzle 51 may be used as the second electrode 62. In the case where the piping 511 is a conductor, the piping 511 may be used as the second electrode 62.

The power source 63 is electrically connected to the first electrode 61 and the second electrode 62 and applies a voltage between the first electrode 61 and the second electrode 62. In the following description, the voltage applied between the first electrode 61 and the second electrode 62 from the power source 63 is also referred to as the "applied voltage". As the power source 63, for example, a power source capable of applying both a direct voltage and an alternating voltage is used. The power source 63 is controlled by the power controller 81 of the controller 8.

In the example shown in Fig. 2, the power source 63 is mechanically and electrically connected via an electric wire to the second electrode 62. The power source 63 is also electrically connected via the second transmitter 65 and the first transmitter 64 to each first electrode 61. The first transmitter 64 is provided in the base part 211 of the substrate holder 21. Specifically, for example, the first transmitter 64 is arranged inside the base part 211 in the vicinity of the lower surface of the base part 211. When the substrate holder 21 rotates, the first transmitter 64 rotates together with the substrate holder 21. The first transmitter 64 is an approximately annular plate-like power-receiving substrate centered on the central axis J1. The lower surface of the first transmitter 64 is provided with a power-receiving coil, and the upper surface of the first transmitter 64 has mounted thereon circuits parts for power reception. The first transmitter 64 is mechanically and electrically connected to each first electrode 61 via an electric wire arranged inside the base part 211.

The second transmitter 65 is arranged inside the cover part 24 and in the vicinity of the upper surface of the cover part 24. That is, the second transmitter 65 is spaced below from the base part 211 of the substrate holder 21. When the substrate holder 21 rotates, the second transmitter 65 remains stationary independently of the rotation of the substrate holder 21. The second transmitter 65 is, for example, an approximately annular plate-like power transmission substrate centered on the central axis J1. The second transmitter 65 faces the first transmitter 64 in the up-down direction while being spaced from the first transmitter 64. The shape of the second transmitter 65 in plan view is, for example, approximately the same as the shape of the first transmitter 64 in plan view. The upper surface of the second transmitter 65 is provided with a power-transmission coil, and the lower surface of the second transmitter 65 has mounted thereon circuit parts for power transmission. The second transmitter 65 is mechanically and electrically connected to the power source 63 via an electric wire.

When the power source 63 applies a voltage between the first electrode 61 and the second electrode 62, the power-transmission coil of the second transmitter 65 and the power-receiving coil of the first transmitter 64 are magnetically coupled together so that electric power is transmitted from the second transmitter 65 to the first transmitter 64 without contact. That is, the first transmitter 64 and the second transmitter 65 serve as a wireless feeder device using a magnetic coupling system. Note that the shapes, structures, arrangement, and so on of the first transmitter 64 and the second transmitter 65 may be changed in various ways. For example, the first transmitter 64 and the second transmitter 65 may serve as a wireless feeder device using an electric-field coupling system.

Fig. 4 is a sectional view showing part of the substrate 9 in enlarged dimensions. In the example shown in Fig. 4, two microstructures 94 are shown among a large number of microstructures 94 that configure a fine pattern (hereinafter, also referred to as the "fine pattern 93") formed on the surface of the substrate 9. The microstructures 94 are fine structures provided on the upper surface of a substrate body formed of silicon (Si). For example, they may be structures formed of a single type of material, or may configure a laminated structure formed by laminating a plurality of types of materials.

The microstructures 94 are, for example, nanosheet channels having a gate all-around (GAA) structure, and a recessed portion 95 is a trench formed between the nanosheet channels. The processing membrane 96 is a metal gate electrode material in a replacement metal gate (RMG). Side wall surfaces 942 of the microstructures 94 that form the recessed portion 95 (i.e., the inner surface of the recessed portion 95) are formed of, for example, a High-k material with a higher relative dielectric constant than silicon dioxide (SiO₂). Examples of the High-k material that can be used include hafnium-, tungsten-, and cobalt-based materials.

The two microstructures 94 described above extend approximately linearly in a direction approximately perpendicular to the plane of the drawing in Fig. 4 (hereinafter, also referred to as the "longitudinal direction"). That is, Fig. 4 shows a longitudinal sectional view of the two microstructures 94 and also shows a longitudinal sectional view of the recessed portion 95 that is a fine gap formed between the two microstructures 94.

The width of the recessed portion 95 in a width direction perpendicular to the longitudinal direction (i.e., the up-down direction in Fig. 4) is, for example, less than or equal to 10 nm. The depth of the recessed portion 95 in the right-left direction in Fig. 4 is, for example, greater than or equal to 20 nm. The aspect ratio of the recessed portion 95, which is the ratio of the depth to the width (i.e., the value obtained by dividing the depth of the recessed portion 95 by the width thereof), is, for example, higher than or equal to 5.

Note that the recessed portion 95 may, for example, be a recessed portion other than a trench, such as an approximately circular hole in plan view. In the case where the recessed portion 95 is a hole, the aforementioned width of the recessed portion 95 corresponds to the diameter of the hole in plan view.

Fig. 4 shows the substrate 9 before etching is performed by the substrate processing apparatus 1. Before etching, the interior of the recessed portion 95 of the substrate 9 and end faces 941 of the two microstructures 94 are covered with the processing membrane 96. The processing membrane 96 is, for example, a conductive membrane formed of a conductor. For example, the processing membrane 96 is a metal membrane that contains one or more types of metals among titanium (Ti), tantalum (Ta), tungsten (W), copper (Cu), and aluminum (Al). For example, the processing membrane 96 contains at least one or more of titanium nitride (TiN), tantalum nitride (TaN), titanium aluminum (TiAl), and titanium aluminum carbide (TiAlC). Note that the processing membrane 96 may be formed of a material other than those described above (e.g., MnO). The thickness of the processing membrane 96 on the end faces 941 of the microstructures 94 (i.e., the thickness in the right-left direction in Fig. 4) is, for example, greater than or equal to 1 nm and less than or equal to 5 nm.

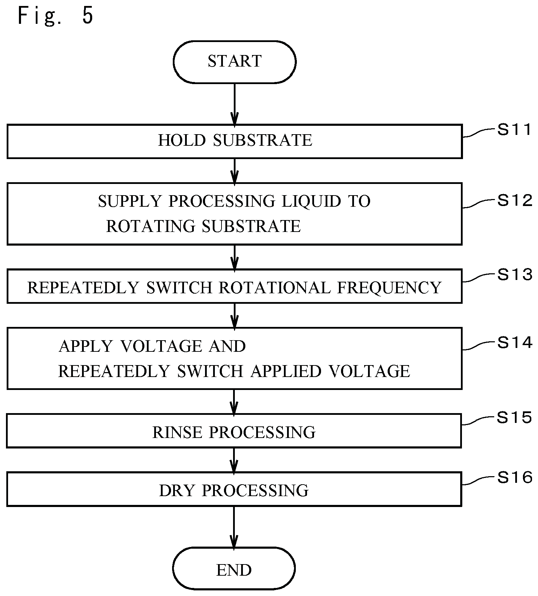

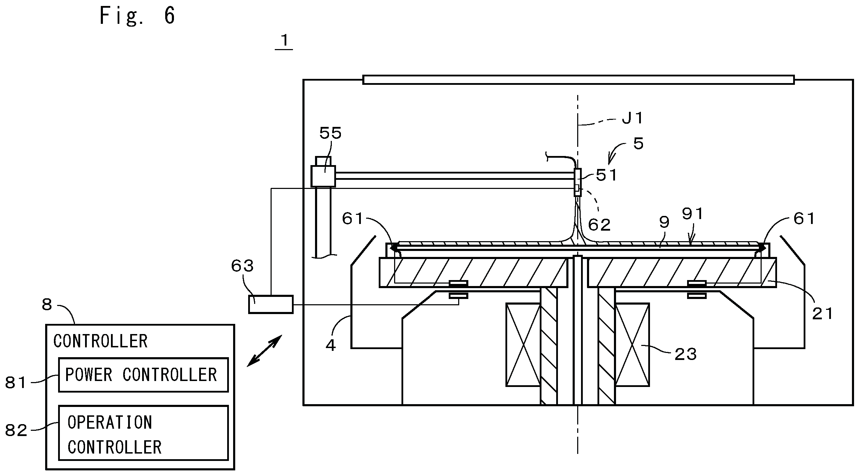

Next, a procedure for processing performed on the substrate 9 by the substrate processing apparatus 1 is described with reference to Figs. 5 and 6. Fig. 5 is a flowchart showing the procedure for processing performed on the substrate 9. Fig. 6 is a side view showing the substrate processing apparatus 1 in which the substrate 9 is being processed.

In the case where processing is performed on the substrate 9, firstly, the substrate 9 is transported into the substrate processing apparatus 1 and held approximately in a horizontal position by the substrate holder 21 as shown in Fig. 2 (step S11). This brings the first electrodes 61 provided on the chuck pins 212 to come into direct contact with the substrate 9 and to be electrically connected to the substrate 9. When the substrate 9 is transported into the apparatus in step S11, the nozzle 51 is located at the aforementioned retracted position.

When the substrate 9 is held by the substrate holder 21, the operation controller 82 of the controller 8 controls the nozzle movement mechanism 55 so that the nozzle 51 is moved horizontally to a position above the substrate 9 as shown in Fig. 6. For example, the nozzle 51 is located above the central portion of the substrate 9 (i.e., the central portion of the substrate 9 in the radial direction).

Then, the operation controller 82 of the controller 8 drives the substrate rotation mechanism 23 to start the rotation of the substrate 9. By the operation controller 82 controlling the processing liquid supplier 5, the processing liquid for etching is continuously supplied from the nozzle 51 toward the upper surface 91 of the substrate 9. The processing liquid spreads across the entire upper surface 91 of the substrate 9 due to centrifugal force caused by the rotation of the substrate 9 and comes into contact with the processing membrane 96 (see Fig. 4) on the substrate 9 (step S12).

In the present embodiment, the processing membrane 96 is a conductive membrane formed of titanium nitride (TiN), and the side wall surfaces 942 of the microstructures 94 (see Fig. 4) are formed of hafnium oxide (HfO₂). The above-described processing liquid is a liquid with conductivity obtained by adding an electrolytic solution to hydrogen peroxide water serving as an etching liquid. The processing liquid has resistivity of, for example, lower than or equal to 0.1 Ω·m and preferably lower than or equal to 0.05 Ω·m. As the above electrolytic solution, for example, an aqueous solution such as hydrochloric acid (HCl), sulfuric acid (H₂SO₄), or ammonia (NH₃) may be used. Note that the resistivity of the processing liquid may be higher than 0.1 Ω·m. The processing liquid may also be a hydrogen peroxide solution alone with nothing such as hydrochloric acid added thereto. The processing liquid may also be SC2 that is a mixed solution of hydrogen peroxide water and a hydrochloric acid solution.

In step S12, approximately the entire upper surface 91 of the substrate 9 is covered with the processing liquid for etching. The processing liquid supplied to the substrate 9 is scattered radially outward from the peripheral edge of the substrate 9 by centrifugal force caused by the rotation of the substrate 9, and is received by the cup part 4. The rotational frequency of the substrate 9 in step S12 is, for example, higher than or equal to 10 rpm, preferably in the range of 100 rpm to 3000 rpm, and more preferably in the range of 300 rpm to 1500 rpm.

In step S12, the nozzle 51 is caused to rock horizontally above the rotating substrate 9 by the operation controller 82 controlling the nozzle movement mechanism 55. For example, the nozzle 51 repeatedly moves back and forth between the central portion of the substrate 9 (i.e., in the vicinity of the central axis J1) and the peripheral edge portion of the substrate 9 in plan view. Alternatively, the nozzle 51 repeatedly moves back and forth on a path from one point on the peripheral edge portion of the substrate 9 through the central portion of the substrate 9 to another point on the peripheral edge portion of the substrate 9 in plan view. That is, the nozzle 51 rocks approximately horizontally at least between the central portion and the peripheral edge portion of the substrate 9 in plan view.

When the nozzle 51 moves back and forth between the central portion and the peripheral edge portion of the substrate 9, the rocking cycle of the nozzle 51 (i.e., the time required for one reciprocal movement) is in the range of, for example, 15 seconds to 2700 seconds. In the case where the nozzle 51 moves back and forth between the peripheral edge portions of the substrate 9, the rocking cycle is in the range of, for example, 30 seconds to 5400 seconds.

In the substrate processing apparatus 1, in parallel with the supply of the processing liquid in step S12, the rotational frequencies of the substrate holder 21 and the substrate 9 are switched by the operation controller 82 controlling the substrate rotation mechanism 23. Specifically, the rotational frequency of the substrate 9 is repeatedly switched between a first rotational frequency and a second rotational frequency different from the first rotational frequency in a predetermined rotational-frequency switching cycle (step S13). The first rotational frequency is in the range of, for example, 300 rpm to 600 rpm. The second rotational frequency is higher than the first rotational frequency and is in the range of, for example, 600 rpm to 1500 rpm. In step S13, the rotation of the substrate 9 is repeatedly accelerated and decelerated between the first rotational frequency and the second rotational frequency. The absolute value for roll acceleration of the substrate 9 is, for example, greater than or equal to 3000 rpm/s. The absolute value for the roll acceleration of the substrate 9 is, for example, less than or equal to 15000 rpm/s and preferably less than or equal to 12500 rpm.

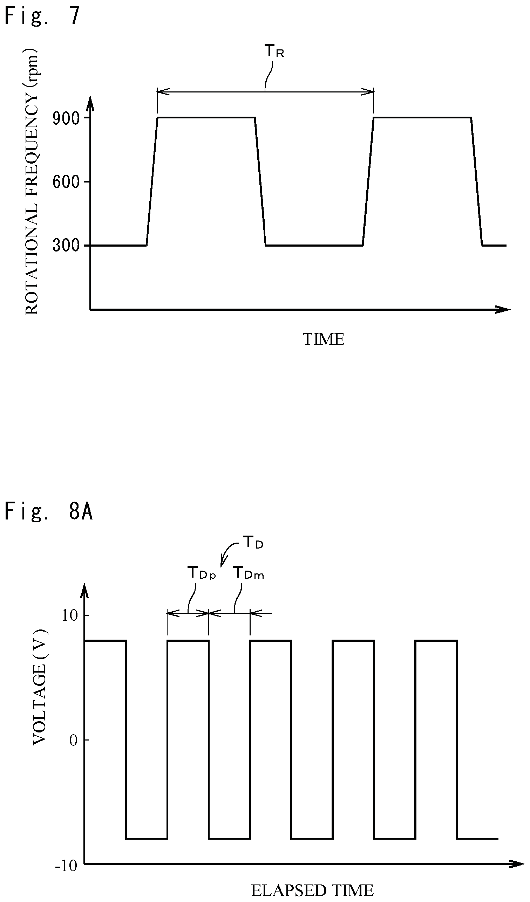

Fig. 7 is a diagram showing the acceleration and deceleration of the rotation of the substrate 9 performed in step S13. In the example shown in Fig. 7, the first rotational frequency is 300 rpm, and the second rotational frequency is 900 rpm. At the time of acceleration from the first rotational frequency to the second rotational frequency and at the time of deceleration from the second rotational frequency to the first rotational frequency, the absolute value for the roll acceleration is, for example, 9000 rpm/s. A rotational-frequency switching cycle T_{R} is in the range of, for example, two seconds to ten seconds and preferably in the range of four seconds to ten seconds. In each rotational-frequency switching cycle T_{R}, the rotational frequency of the substrate 9 is maintained at the first rotational frequency for a predetermined period of time and then maintained at the second rotational frequency for a predetermined period of time. The duration in time when the rotational frequency is maintained at the first rotational frequency and the duration in time when the rotational frequency is maintained at the second rotational frequency are each in the range of, for example, two seconds to five seconds.

Note that the first rotational frequency, the second rotational frequency, the roll acceleration, the durations in time when the rotational frequency is maintained at the first rotational frequency and at the second rotational frequency, and the rotational-frequency switching cycle T_{R} are not limited to the values or ranges described above, and may be changed in various ways. For example, each of the durations in time when the rotational frequency is maintained at the first rotational frequency and at the second rotational frequency may be zero seconds. In step S13, there may be moments when the rotational frequency of the substrate 9 becomes 0 rpm, or the substrate 9 may be rotated in the opposite circumferential direction by switching of the rotational frequency.

On the rotating substrate 9, the processing liquid existing within the recessed portion 95 (see Fig. 4) is restricted from flowing by the microstructures 94, and flows together with the substrate 9 in the circumferential direction at approximately the same flow speed as the rotational speed of the substrate 9. On the other hand, the processing liquid existing on the upper surface 91 of the substrate 9 outside the recessed portion 95 is substantially not restricted from flowing due to the microstructures 94. Therefore, during acceleration and deceleration of the rotation of the substrate 9, the flow speed of the processing liquid in the circumferential direction outside the recessed portion 95 differs from the rotational speed of the substrate 9 due to the effect of inertia.

In this way, during acceleration and deceleration of the rotation of the substrate 9, difference in the flow speed in the circumferential direction occurs between the processing liquid within the recessed portion 95 and the processing liquid on the recessed portion 95 (i.e., the processing liquid existing vertically above the recessed portion 95 and outside the recessed portion 95). As a result, a vortex forms in the processing liquid in the upper portion of the recessed portion 95. This vortex is, for example, a vortex centered on an axis that is approximately perpendicular to the depth direction of the recessed portion 95 (i.e., the right-left direction in Fig. 4). When such a vortex forms in the upper portion of the recessed portion 95, the flow of the processing liquid moves downward due to the vortex, causing the processing liquid to flow within the recessed portion 95. As a result, the processing liquid is more likely to again come into contact with the side wall surfaces 942 of the microstructures 94. This increases the etch rate of the processing membrane 96 within the recessed portion 95.

In the substrate processing apparatus 1, in parallel with the supply of the processing liquid in step S12 and the switching of the rotational frequency in step S13, the power controller 81 of the controller 8 controls the power source 63 so that a voltage is applied between the first electrode 61 and the second electrode 62. Accordingly, the voltage is applied via the processing liquid on the substrate 9 between the second electrode 62 and the substrate 9 that is electrically connected to the first electrode 61. In other words, the substrate 9 and the second electrode 62 serve as a pair of electrodes with the processing liquid sandwiched therebetween, and the voltage is applied between the pair of electrodes.

The voltage applied between the first electrode 61 and the second electrode 62 is repeatedly switched between a first voltage and a second voltage different from the first voltage in a predetermined voltage switching cycle under the control of the power controller 81. Accordingly, the potential on the side wall surfaces 942 (see Fig. 4) of the microstructure 94 is repeatedly switched between a first potential and a second potential in the aforementioned voltage switching cycle (step S14).

The power source 63 applies a voltage to the first electrode 61 with reference to the potential of the second electrode 62. Thus, the first potential and the second potential are potentials determined with reference to the second electrode 62. The first potential is higher than or equal to zero volts (V). The second potential is lower than or equal to 0V and lower than the first potential. Thus, in the case where the first potential is 0V, the second potential is less than 0V. The first potential is, for example, less than or equal to +8V. The second potential is, for example, higher than or equal to -8V. The upper limit for the first potential and the lower limit for the second potential may be changed in various ways.

The aforementioned voltage switching cycle is preferably more than or equal to 0.05 seconds. The voltage switching cycle is preferably less than or equal to 20 seconds. In the case where the applied voltage is a direct voltage, the voltage switching cycle is preferably more than or equal to 0.5 seconds, more preferably more than equal to one seconds, and yet more preferably more than or equal to two seconds. In the case where the applied voltage is a direct voltage, the voltage switching cycle is preferably less than or equal to 18 seconds, more preferably less than or equal to 12 seconds, and yet more preferably less than or equal to 6 seconds.

In the case where the applied voltage is an alternating voltage, the aforementioned voltage switching cycle of more than or equal to 0.05 seconds corresponds to a frequency of lower than or equal to 20 Hz, and the voltage switching cycle of less than or equal to 20 seconds corresponds to a frequency of higher than or equal to 0.05 Hz. In the case where the applied voltage is an alternating voltage, the voltage switching cycle is preferably more than or equal to 0.1 seconds (i.e., a frequency of lower than or equal to 10 Hz) and more preferably more than or equal to 0.2 seconds (i.e., a frequency of lower than or equal to 5 Hz). In the case where the applied voltage is an alternating voltage, the voltage switching cycle is also preferably less than or equal to two seconds (i.e., a frequency of higher than or equal to 0.5 Hz) and more preferably less than or equal to one seconds (i.e., a frequency of higher than or equal to 1 Hz).

The voltage switching cycle in step S14 is shorter than the aforementioned rocking cycle of the nozzle 51. The rocking cycle is, for example, 300 times to 600 times of the voltage switching cycle. The voltage switching cycle is also, for example, shorter than or equal to the aforementioned rotational-frequency switching cycle. The rotational-frequency switching cycle is preferably an integral multiple of the voltage switching cycle (i.e., one or two times) and more preferably an even multiple of the voltage switching cycle. The switching of the rotational frequency of the substrate 9 in step S13 (i.e., the start of acceleration or deceleration of the rotation of the substrate 9) is performed approximately simultaneously with the switching of the applied voltage in step S14. Note that the voltage switching cycle may be longer than the rotational-frequency switching cycle.

The switching of the rotational frequency of the substrate 9 in step S13 and the switching of the applied voltage in step S14 (i.e., the switching of the potential on the side wall surfaces 942) are continuously performed for a predetermined period of time in parallel with the supply of the processing liquid to the rotating substrate 9. Accordingly, etching (so-called electrolyte etching) is performed on the processing membrane 96 on the substrate 9 as described above.

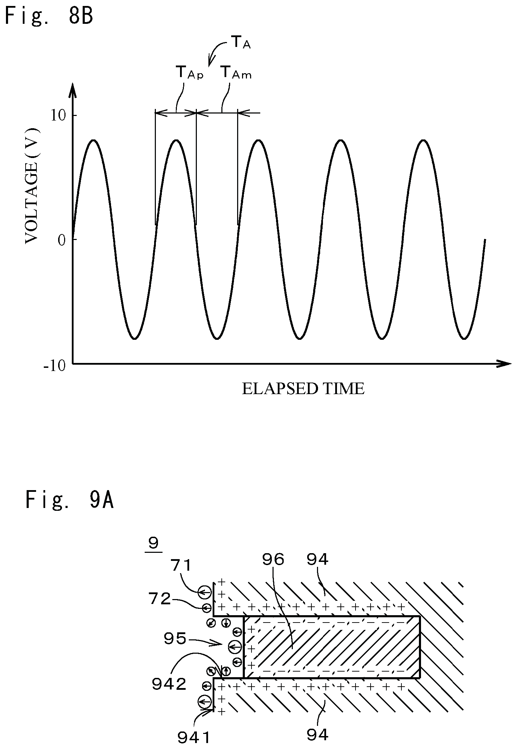

Figs. 8A and 8B are diagrams each showing one example of the waveform of the voltage applied from the power source 63 in step S14. Fig. 8A shows one example of the waveform when the applied voltage is a direct voltage, and Fig. 8B shows one example of the waveform when the applied voltage is an alternating voltage. In Figs. 8A and 8B, the horizontal axis indicates the elapsed time, and the vertical axis indicates the voltage applied between the first electrode 61 and the second electrode 62. In the specification of the present invention, it is assumed that the applied voltage is positive when the potential of the first electrode 61 is higher than the potential of the second electrode 62, and the applied voltage is negative when the potential of the first electrode 61 is lower than the potential of the second electrode 62. In the following description, the case where the applied voltage is positive is also expressed as "applying a positive voltage to the first electrode 61", and the case where the applied voltage is negative is also expressed as "applying a negative voltage to the first electrode 61".

In the example shown in Fig. 8A, the waveform of the applied voltage is a rectangular wave. A maximum value (i.e., the first voltage) of the applied voltage is +8V, and a minimum value (i.e., the second voltage) of the applied voltage is -8V. As described above, the applied voltage is repeatedly switched between the first voltage and the second voltage in a predetermined switching cycle T_{D}. In the following description, in each switching cycle T_{D} of the applied voltage, a duration in time when the applied voltage is positive is also referred to as a "first application time T_{Dp}", and a duration in time when the applied voltage is negative is also referred to as a "second application time T_{Dm}". In the example shown in Fig. 8A, the first application time T_{Dp} and the second application time T_{Dm} are the same and equal to T_{D}/2. Note that the first voltage and the second voltage may be changed as appropriate, and their absolute values do not necessarily have to be the same. The first application time T_{Dp} and the second application time T_{Dm} also do not necessarily have to be the same, and may be different.

Fig. 8B shows one example of the waveform when the applied voltage is an alternating voltage. In the example shown in Fig. 8B, the waveform of the alternating voltage is a sinusoidal wave. In Fig. 8B, the vertical axis indicates the instantaneous value of the applied voltage. A maximum value (i.e., the first voltage) of the applied voltage is +8V, and a minimum value (i.e., the second voltage) of the applied voltage is -8V. As described above, the applied voltage is repeatedly switched between the first voltage and the second voltage in a predetermined switching cycle T_{A}. In the following description, in each switching cycle T_{A} of the applied voltage, a duration in time when the applied voltage is positive is also referred to as a "first application time T_{Ap}", and a duration in time when the applied voltage is negative is also referred to as a "second application time T_{Am}". In the example shown in Fig. 8B, the first application time T_{Ap} and the second application time T_{Am} are the same and equal to T_{A}/2. Note that the first voltage and the second voltage may be changed as appropriate, and their absolute values do not necessarily have to be the same. The first application time T_{Ap} and the second application time T_{Am} also do not necessarily have to be the same, and may be different. In the case where the applied voltage is an alternating voltage, the waveform of the applied voltage is not limited to a sinusoidal wave, and for example, may be a triangular wave or a sawtooth wave.

In step S14 described above, the power controller 81 controls the power source 63 so that the applied voltage is repeatedly switched between the first voltage and the second voltage. This accelerates the etching of the processing membrane 96 and increases the etch rate. In particular, the etching of the processing membrane 96 within the recessed portion 95 is accelerated, which results in an increase in the etch rate.

Strictly speaking, the principle behind the increase in the etch rate of the processing membrane 96 within the recessed portion 95 as a result of repeatedly switching the applied voltage has not yet been determined. The following description provides a plurality of conceivable principles as candidates for this principle.

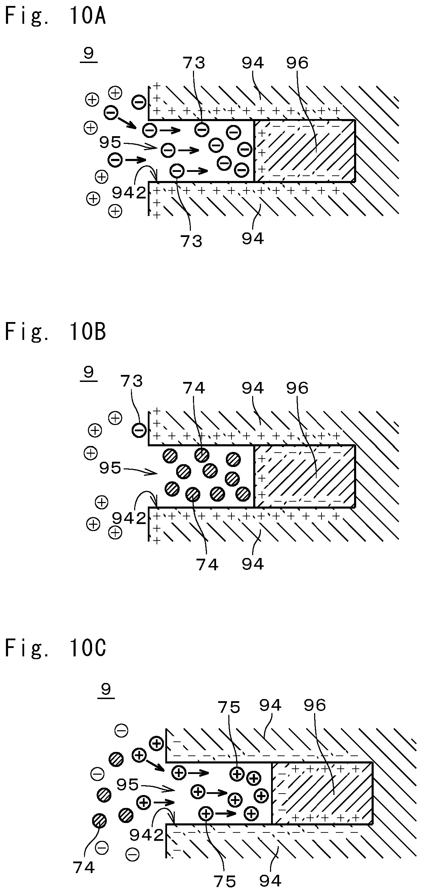

First, a first principle is described with reference to Figs. 9A to 9D, which are sectional views approximately the same as the sectional view in Fig. 4. Figs. 9A to 9D show situations in which the etching of the processing membrane 96 shown in Fig. 4 has progressed to some extent so that the processing membrane 96 on the end faces 941 of the microstructures 94 has been removed, and the processing membrane 96 inside the recessed portion 95 has also been removed slightly. To simplify the drawings, Figs. 9A to 9D schematically illustrate the processing membrane 96 such that its surface (i.e., the end face on the side opposite the bottom of the recessed portion 95; the face on the left side in the drawings) becomes perpendicular to the right-left direction. The same also applies to Figs.10A to 10D, which will be described later. In the examples shown in Figs. 9A to 9D, the processing liquid used in etching is described as containing hydrogen peroxide as an etchant.

Fig. 9A shows a state in which a positive voltage is applied to the first electrode 61 (see Fig. 2). The application of the positive voltage to the first electrode 61 causes the surface of the processing membrane 96 within the recessed portion 95 to become positively charged. The side wall surfaces 942 of the two microstructures 94 located on the opposite sides of the recessed portion 95 (i.e., the inner surface of the recessed portion 95) and the end faces 941 thereof also become positively charged. Thus, hydrogen peroxide molecules 71 and water molecules 72, which are polar molecules (also referred to as dipoles), adsorb onto the surface of the processing membrane 96 and the surfaces of the microstructures 94 (i.e., the side wall surfaces 942 and the end faces 941 described above). Specifically, portions of the hydrogen peroxide molecules 71 where the negative charge is concentration and portions of the water molecules 72 where the negative charge is concentrated adsorb onto the surfaces of the processing membrane 96 and the microstructures 94.

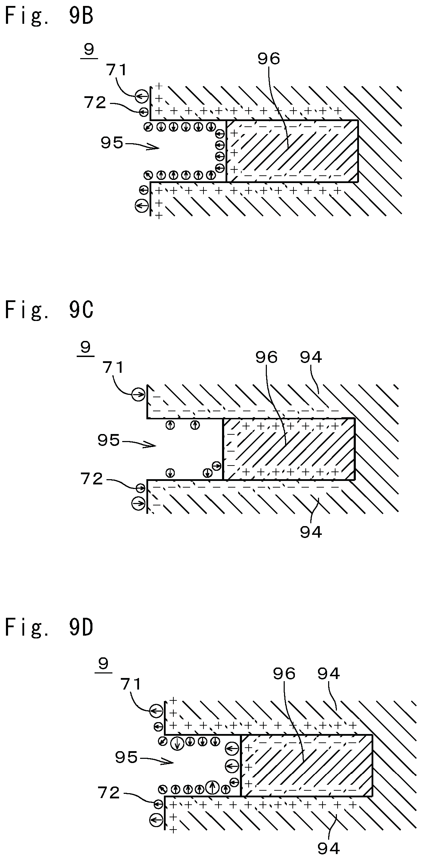

In Fig. 9A, the hydrogen peroxide molecules 71 are schematically indicated by circles, and a deviation in the charge of the hydrogen peroxide molecules 71 is indicated by an arrow within each circle. Specifically, portions of the hydrogen peroxide molecules 71 where the positive charge is concentrated are indicated by the tips of the arrows (i.e., arrowheads), and portions of the hydrogen peroxide molecules 71 where the negative charge is concentrated are indicated by the ends of the arrows on the side opposite the tips thereof. Approximately the same also applies to the water molecules 72. Note that the circles schematically indicating the water molecules 72 are illustrated smaller than the circles schematically indicating the hydrogen peroxide molecules 71. The same also applies to Figs. 9B and 9D.

When a positive voltage is applied to the first electrode 61, the processing membrane 96 is etched by the hydrogen peroxide molecules 71 adsorbing on the surface of the processing membrane 96. The hydrogen peroxide molecules 71 used in the etching of the processing membrane 96 turn into hydroxide ions (OH⁻) or the like and disappear from the surface of the processing membrane 96. Thus, as the etching of the processing membrane 96 progresses, the hydrogen peroxide molecules 71 decrease in number or disappear from the surface of the processing membrane 96 and from portions of the surfaces of the microstructures 94 that are located in the vicinity of the processing membrane 96 (i.e., the inner surface of the recessed portion 95), and as shown in Fig. 9B, the surface of the processing membrane 96 and the inner surface of the recessed portion 95 are covered with the water molecules 72. As a result, the adsorption of the hydrogen peroxide molecules 71 onto the surface of the processing membrane 96 is inhibited, which lowers the etch rate of the processing membrane 96 or stops the etching of the processing membrane 96.

In view of this, the substrate processing apparatus 1 causes the surfaces of the processing membrane 96 and the microstructures 94 to become negatively charged as shown in Fig. 9C by switching the polarity of the voltage applied to the first electrode 61 with predetermined timing so that a negative voltage is applied to the first electrode 61. This causes the water molecules 72 adsorbing on the surfaces of the processing membrane 96 and the microstructures 94 (e.g., the inner surface of the recessed portion 95) to become electrolyzed into hydrogen molecules and hydroxide ions and to be removed from the surfaces of the processing membrane 96 and the microstructures 94. As a result, the hydrogen peroxide molecules 71 become capable of adsorbing onto the surface of the processing membrane 96.

The substrate processing apparatus 1 also causes the surfaces of the processing membrane 96 and the microstructures 94 (e.g., the inner surface of the recessed portion 95) to become positively charged as shown in Fig. 9D by switching the polarity of the voltage applied to the first electrode 61 with predetermined timing so that a positive voltage is applied to the first electrode 61. This causes the hydrogen peroxide molecules 71 to adsorb onto the surface of the processing membrane 96 and etch the processing membrane 96. As a result, the etching of the processing membrane 96 within the recessed portion 95 is accelerated, resulting in an increase in the etch rate.

Next, a second principle is described with reference to Figs. 10A to 10D. Fig. 10A shows a state in which a positive voltage is applied to the first electrode 61 (see Fig. 2). The application of the positive voltage to the first electrode 61 causes the side wall surfaces 942 of the two microstructures 94 (i.e., the inner surface of the recessed portion 95) located on the opposite sides of the recessed portion 95 to become positively charged. In other words, the potential on the side wall surfaces 942 of the microstructures 94 becomes higher than the potential in the processing liquid. This allows minus ions 73 existing as etchants around the recessed portion 95 to easily enter the recessed portion 95. As a result, the area of contact between the surface of the processing membrane 96 and the minus ions 73 serving as etchants increases, which accelerates the etching of the processing membrane 96.

As the etching of the processing membrane 96 progresses, products 74 that are generated by etching and become negatively charged increase in number and become trapped in the recessed portion 95 as shown in Fig. 10B. This makes it hard for the minus ions 73 serving as etchants to enter the recessed portion 95. As a result, the area of contact between the minus ions 73 and the processing membrane 96 decreases, which lowers the etch rate of the processing membrane 96 or stops the etching of the processing membrane 96. In Fig. 10B, the products 74 are hatched in order to facilitate understanding of the drawing (the same also applies to Fig. 10C).

In view of this, the polarity of the voltage applied to the first electrode 61 is switched with predetermined timing so that a negative voltage is applied to the first electrode 61. This causes the side wall surfaces 942 of the two microstructures 94 located on the opposite sides of the recessed portion 95 (i.e., the inner surface of the recessed portion 95) to become negatively charged as shown in Fig. 10C. In other words, the potential on the side wall surfaces 942 of the microstructures 94 becomes lower than the potential in the processing liquid. As a result, plus ions 75 existing around the recessed portion 95 enter the recessed portion 95, and the products 74 trapped in the recessed portion 95 are discharged to the outside of the recessed portion 95.

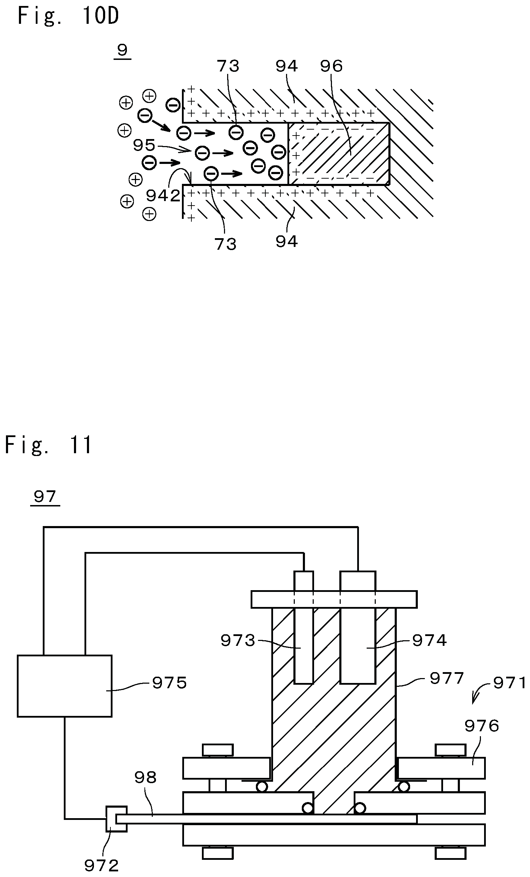

Thereafter, the polarity of the voltage applied to the first electrode 61 is switched with predetermined timing so that a positive voltage is applied to the first electrode 61. This causes the side wall surfaces 942 of the microstructures 94 (i.e., the inner surface of the recessed portion 95) to become positively charged as shown in Fig. 10D. As a result, the minus ions 73 existing as etchants around the recessed portion 95 enter the recessed portion 95 and come into contact with the processing membrane 96. This accelerates the etching of the processing membrane 96 and increases the etch rate.

Next, a third principle is described. In the above-described etching of the processing membrane 96, a positive voltage and a negative voltage are alternately applied to the first electrode 61. Then, it has been confirmed that air bubbles form inside the recessed portion 95 when one of the positive voltage and the negative voltage is applied, whereas no air bubbles form when the other voltage is applied. Thus, if only the one voltage is continuously applied to the first electrode 61, air bubbles increase in number and become trapped in the recessed portion 95. This lowers the etch rate of the processing membrane 96 or stops the etching of the processing membrane 96. In view of this, the polarity of the voltage applied to the first electrode 61 is switched with predetermined timing so that the air bubbles are discharged to the outside of the recessed portion 95. This prevents air bubbles from inhibiting the etching and thereby increases the etch rate.

Next, a fourth principle is described. The following description is given on the assumption that the processing membrane 96 is a TiN membrane, and the processing liquid used for etching is obtained by adding hydrochloric acid as an electrolytic solution to an aqueous solution of hydrogen peroxide. If a positive voltage is applied to the first electrode 61, chlorine ions (Cl⁻) that serve as ligands in the processing liquid can easily enter the recessed portion 95. This accelerates the etching of the processing membrane 96 and increases the etch rate. As the etching progresses, complexes (Ti-Cl) produced by etching increase in number and become trapped in the recessed portion 95, making it hard for the ligands to enter the recessed portion 95. As a result, the etch rate of the processing membrane 96 is lowered, or the etching of the processing membrane 96 stops.

In view of this, the polarity of the voltage applied to the first electrode 61 is switched with predetermined timing so that a negative voltage is applied to the first electrode 61. This causes the complexes to be discharged to the outside of the recessed portion 95. Thereafter, a positive voltage is applied to the first electrode 61, allowing the ligands in the processing liquid to easily enter the recessed portion 95 as described above. This accelerates the etching of the processing membrane 96 and increases the etch rate.

Note that it has not yet been determined which of the aforementioned first to fourth principles is dominant. There is also a possibility that an increase in the etch rate may be caused by a combination of these principles and other principles, or may be caused by a principle other than the above-described principles. However, in any case, the etching of the processing membrane 96 within the recessed portion 95 can be accelerated by repeatedly switching the applied voltage in the voltage switching cycle of 0.05 seconds or more so that the potential on the side wall surfaces 942 of the microstructures 94 is repeatedly switched between the first potential and the second potential in step S14 described above.

In the substrate processing apparatus 1, after a predetermined processing time has elapsed since the start of step S14, the supply of the processing liquid to the substrate 9, the rocking of the nozzle 51, the switching of the rotational frequency of the substrate 9, and the application of the voltage from the power source 63 are stopped, and the etching of the substrate 9 terminates. When the etching ends, a rinsing liquid is supplied from the nozzle 51 to the central portion of the upper surface 91 of the substrate 9, and the rotational frequency of the substrate 9 is increased.

The rinsing liquid supplied to the substrate 9 spreads across the entire upper surface 91 of the substrate 9 due to centrifugal force caused by the rotation of the substrate 9. Accordingly, rinse processing is performed to wash away the aforementioned processing liquid and so on adhering on the substrate 9 (step S15). The rotational frequency of the substrate 9 in step S15 is, for example, higher than or equal to 800 rpm. The rinsing liquid on the substrate 9 is scattered radially outward from the peripheral edge of the substrate 9 by the centrifugal force caused by the rotation of the substrate 9, and is received by the cup part 4. Note that the position of the nozzle 51 in the up-down direction during the supply of the rinsing liquid may be the same as or different from the position of the nozzle 51 in the up-down direction in step S12.

After the rinse processing is performed for a predetermined period of time on the substrate 9, the supply of the rinsing liquid is stopped. Then, the rinsing liquid on the substrate 9 is shaken off and removed, i.e., dry processing is performed on the substrate 9 (step S16). The rotational frequency of the substrate 9 in step S16 is, for example, higher than or equal to 1000 rpm. Note that the dry processing may be performed using any of various known methods. After the dry processing of the substrate 9 ends, the rotation of the substrate 9 is stopped, and the substrate 9 is transported out of the substrate processing apparatus 1.

Next, Examples 1 to 28 of the above-described etching of the processing membrane 96 within the recessed portion 95 and Comparative Examples 1 to 3 are described with reference to Tables 1 to 7.

**Table 1**

| | Processing Liquid | Applied Voltage | | | | Amount of Etching (nm) |
|---|---|---|---|---|---|---|
| | | Type | Second Voltage (V) | First Voltage (V) | Switching Cycle (sec) | |
| Example 1 | SC2 | DC | -8 | +8 | 6 | 24 |
| Example 2 | SC2 | DC | -1 | +1 | 6 | 26 |
| Example 3 | SC2 | DC | -0.8 | +0.8 | 6 | 25.5 |
| Example 4 | SC2 | DC | -0.6 | +0.6 | 6 | 25.5 |
| Example 5 | SC2 | DC | -0.5 | +0.5 | 6 | 27.5 |
| Comparative Example 1 | SC2 | - | - | - | - | 11 |

**Table 2**

| | Processing Liquid | Applied Voltage | | | | Amount of Etching (nm) |
|---|---|---|---|---|---|---|
| | | Type | Second Voltage (V) | First Voltage (V) | Switching Cycle (sec) | |
| Example 6 | SC2 | DC | -8 | 0 | 6 | 26 |
| Example 7 | SC2 | DC | -8 | +1 | 6 | 25.5 |
| Example 8 | SC2 | DC | -8 | off | 6 | 25.5 |
| Example 9 | SC2 | DC | -8 | +8 | 6 | 27 |
| Example 10 | SC2 | DC | -1 | +1 | 6 | 25.5 |
| Comparative Example 2 | SC2 | DC | -8 | -2 | 6 | 11 |

**Table 3**

| | Processing Liquid | Applied Voltage | | | | Amount of Etching (nm) |
|---|---|---|---|---|---|---|
| | | Type | Second Voltage (V) | First Voltage (V) | Switching Cycle (sec) | |
| Example 11 | SC2 | DC | -1 | +1 | 2 | 20.5 |
| Example 12 | SC2 | DC | -1 | +1 | 6 | 21.5 |
| Example 13 | SC2 | DC | -1 | +1 | 12 | 22 |
| Example 14 | SC2 | DC | -1 | +1 | 18 | 19.5 |
| Comparative Example 1 | SC2 | - | - | - | - | 11 |

**Table 4**

| | Processing Liquid | Applied Voltage | | | | | Amount of Etching (nm) |
|---|---|---|---|---|---|---|---|
| | | Type | Second Voltage (V) | First Voltage (V) | Frequency (Hz) | Switching Cycle (sec) | |
| Example 15 | SC2 | AC | -1 | +1 | 0.5 | 2 | 21 |
| Example 16 | SC2 | AC | -1 | +1 | 1 | 1 | 22 |
| Example 17 | SC2 | AC | -1 | +1 | 5 | 0.2 | 16.5 |
| Comparative Example 1 | SC2 | - | - | - | - | | 11 |

**Table 5**

| | Processing Liquid | Applied Voltage | | | | Amount of Etching (nm) |
|---|---|---|---|---|---|---|
| | | Type | Second Voltage (V) | First Voltage (V) | Switching Cycle (sec) | |
| Example 18 | H₂O₂ | DC | -1 | +1 | 2 | 18 |
| Example 19 | H₂O₂ | DC | -2 | +2 | 2 | 18.5 |
| Example 20 | H₂O₂ | DC | -3 | +3 | 2 | 19 |
| Example 21 | H₂O₂ | DC | -5 | +5 | 2 | 22.5 |
| Example 22 | H₂O₂ | DC | -8 | +8 | 2 | 24.5 |
| Comparative Example 3 | H₂O₂ | - | - | - | - | 15.5 |

**Table 6**

| | Processing Liquid | Applied Voltage | | | | Amount of Etching (nm) |
|---|---|---|---|---|---|---|
| | | Type | Second Voltage (V) | First Voltage (V) | Switching Cycle (sec) | |
| Example 23 | H₂O₂ | DC | -5 | +5 | 0.5 | 19 |
| Example 24 | H₂O₂ | DC | -5 | +5 | 1 | 21 |
| Example 25 | H₂O₂ | DC | -5 | +5 | 2 | 20 |
| Comparative Example 3 | H₂O₂ | - | - | - | - | 15.5 |

**Table 7**

| | Processing Liquid | Applied Voltage | | | | | Amount of Etching (nm) |
|---|---|---|---|---|---|---|---|
| | | Type | Second Voltage (V) | First Voltage (V) | Frequency (Hz) | Switching Cycle (sec) | |
| Example 26 | H₂O₂ | AC | -5 | +5 | 1 | 1 | 20.5 |
| Example 27 | H₂O₂ | AC | -5 | +5 | 10 | 0.1 | 26 |
| Example 28 | H₂O₂ | AC | -5 | +5 | 20 | 0.05 | 17.5 |
| Comparative Example 3 | H₂O₂ | - | - | - | - | | 15.5 |

In Examples 1 to 28 and Comparative Example 2, the etching of the processing membrane 96 in the substrate processing apparatus 1 was simulated, and processing corresponding to steps S11 to S16 described above was performed on a test specimen 98 using laboratory equipment 97 shown in Fig. 11. In Comparative Examples 1 and 3, the application of the voltage in step S14 was omitted. Note that this processing on the test specimen 98 was conducted in an ambient atmosphere at an ambient temperature (e.g., 25°C).

The laboratory equipment 97 includes an electrolytic cell 971, a test-specimen electrode 972, a counter electrode 973, a reference electrode 974, and a power source 975. As the electrolytic cell 971, "VM-3" manufactured by EC Frontier Co., Ltd. was used. The test specimen 98 was set on a base 976 of the electrolytic cell 971, and a cell cap 977 on the base 976 was filled with a processing liquid for etching. The upper surface of the test specimen 98 was in contact with the processing liquid within the cell cap 977. The area of contact of the test specimen 98 with the processing liquid was defined as 1 cm² by an O-ring. The upper surface of the test specimen 98 was provided with a plurality of microstructures 94 that formed a plurality of recessed portions 95 described above (see Fig. 4).

As the test-specimen electrode 972 corresponding to the above-described first electrode 61 (see Fig. 2), an alligator clip was used. By clipping the end portion of the test specimen 98 with the alligator clip, the test-specimen electrode 972 and the test specimen 98 were electrically connected to each other. As the counter electrode 973, "CE-100" manufactured by EC Frontier Co., Ltd. was used. As the reference electrode 974, "RE-T1 6" manufactured by EC Frontier Co., Ltd. was used. "RE-T16" was a silver-silver chloride electrode (Ag/AgCl electrode) using a potassium chloride (KCl) solution with a concentration of 3.0 mol/L(mol/L) as an internal solution, and a potential relative to the NHE (normal hydrogen electrode) was +0.208V at 25°C. The counter electrode 973 and the reference electrode 974 were inserted from the upper portion of the cell cap 977 to the interior and came into contact with the processing liquid within the cell cap 977. As the power source 975, "VSP-300-SC" manufactured by Bio-Logic Science instruments SAS and serving as a potentiostat was used.

In Examples 1 to 17 and Comparative Examples 1 and 2 shown in Tables 1 to 4, the processing liquid used in an etching process was SC2, and the processing time for the etching process (i.e., the processing time in step S14) was 60 minutes. The processing liquid was a mixed solution obtained by mixing hydrogen peroxide water with a concentration of about 20 mol%, a hydrochloric acid solution with a concentration of about 22 mol%, and DIW in a volume ratio of 1:1:8.

In Examples 18 to 28 and Comparative Example 3 shown in Tables 5 to 7, the processing liquid used in the etching process was hydrogen peroxide water, and the processing time for the etching process (i.e., the processing time in step S14) was 120 minutes. The processing liquid was a mixed solution obtained by mixing hydrogen peroxide water with a concentration of about 20 mol% and DIW in a volume ratio of 1:8. No other chemical solutions such as hydrochloric acid were added to the processing liquid. That is, the concentration of the hydrochloric acid in the processing liquid was 0 mol% and 0% by mass.

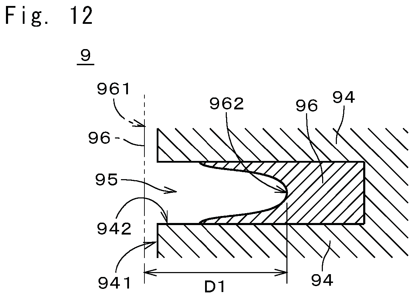

The amount of etching in Tables 1 to 7 was expressed as a distance D1 in the depth direction of the recessed portion 95 (i.e., the right-left direction in Fig. 12) between a surface 961 of the processing membrane 96 before the start of the etching, which was indicated by the chain double-dashed line in Fig. 12, and a surface 962 of the processing membrane 96 after the etching for a predetermined duration in time, which was indicated by the solid line in Fig. 12. As shown in Fig. 12, the distance D1 was a distance between the surface 961 of the processing membrane 96 and the lowest end of the surface 962 of the processing membrane 96 within the recessed portion 95 (i.e., a farthest position in the depth direction from the surface 961). The amount of etching was expressed as an arithmetical mean of distances D1 obtained from six recessed portions 95. These distances D1 were obtained by observing SEM images of cross-sections of the substrate 9.

As described above, in Examples 1 to 17 and Comparative Examples 1 and 2 shown in Tables 1 to 4, SC2 was used as the processing liquid. In Examples 1 to 5 shown in Table 1, the amount of etching of the processing membrane 96 was measured by changing the first and second voltages used as the applied voltage in step S14. In Example 1, the voltage applied from the power source 975 was a direct voltage, the second voltage was set to -8V, and the first voltage was set to +8V. The voltage switching cycle of the applied voltage was six seconds. That is, in Example 1, the potential on the side wall surfaces 942 of the microstructures 94 (i.e., the inner surface of the recessed portion 95) was switched between the second potential of -8V and the first potential of +8V in the voltage switching cycle of six seconds. In Example 1, the amount of etching was 24 nm.

Example 2 was the same as Example 1, except that the second voltage was set to -1V, and the first voltage was set to +1V. In Example 2, the potential on the side wall surfaces 942 of the microstructures 94 was switched between the second potential of -1V and the first potential of +1V in the voltage switching cycle of six seconds. In Example 2, the amount of etching was 26 nm.

Example 3 was the same as Example 1, except that the second voltage was set to -0.8V, and the first voltage was set to +0.8V. In Example 3, the potential on the side wall surfaces 942 of the microstructures 94 was switched between the second potential of -0.8V and the first potential of +0.8V in the voltage switching cycle of six seconds. In Example 3, the amount of etching was 25.5nm.

Example 4 was the same as Example 1, except that the second voltage was set to -0.6V, and the first voltage was set to +0.6V. In Example 4, the potential on the side wall surfaces 942 of the microstructures 94 was switched between the second potential of -0.6V and the first potential of +0.6V in the voltage switching cycle of six seconds. In Example 4, the amount of etching was 25.5 nm.

Example 5 was the same as Example 1, except that the second voltage was set to -0.5V, and the first voltage was set to +0.5V. In Example 5, the potential on the side wall surfaces 942 of the microstructures 94 was switched between the second potential of -0.5V and the first potential of +0.5V in the voltage switching cycle of six seconds. In Example 5, the amount of etching was 27.5 nm.

In Comparative Example 1, the application of the voltage in step S14 was omitted as described above. In Comparative Example 1, the amount of etching was 11 nm.

A comparison between Examples 1 to 5 and Comparative Example 1 shows that, even if the applied voltage differed, the etch rate of the processing membrane 96 within the recessed portion 95 was increased by performing step S14 (the switching of the applied voltage).

In Examples 6 to 10 and Comparative Example 2 shown in Table 2, the amount of etching of the processing membrane 96 was measured by changing the first and second voltages used as the applied voltage in step S14. In Example 6, the voltage applied from the power source 975 was a direct voltage, the second voltage was set to -8V, and the first voltage was set to 0V. The voltage switching cycle of the applied voltage was six seconds. That is, in Example 6, the potential on the side wall surfaces 942 of the microstructures 94 (i.e., the inner surface of the recessed portion 95) was switched between the second potential of -8V and the first potential of 0V in the voltage switching cycle of six seconds. In Example 6, the amount of etching was 26 nm.

Example 7 was the same as Example 6, except that the first voltage was set to +1V. In Example 7, the potential on the side wall surfaces 942 of the microstructures 94 was switched between the second potential of -8V and the first potential of +1V in the voltage switching cycle of six seconds. In Example 7, the amount of etching was 25.5 nm.

Example 8 was the same as Example 6, except that the power source 975 was off at the time when the first voltage was scheduled to be applied. When the power source 975 was off, an open-circuit potential on the surface of the test specimen 98 was in the range of +0.6V to +0.8V. In Example 8, the potential on the side wall surfaces 942 of the microstructures 94 was switched between the second potential of -8V and the above open-circuit potential serving as the first potential in the voltage switching cycle of six seconds. In Example 8, the amount of etching was 25.5 nm.

Example 9 was the same as Example 6, except that the first voltage was set to +8V. In Example 9, the potential on the side wall surfaces 942 of the microstructures 94 was switched between the second potential of -8V and the first potential of +8V in the voltage switching cycle of six seconds. In Example 9, the amount of etching was 27 nm.

Example 10 was the same as Example 7, except that the second potential was set to -1V. In Example 10, the potential on the side wall surfaces 942 of the microstructures 94 was switched between the second potential of -1V and the first potential of +1V in the voltage switching cycle of six seconds. In Example 10, the amount of etching was 25.5 nm.

Note that Examples 9 and 10 used the same experimental conditions as Examples 1 to 2 shown in Table 1, but differed in the experiment date or the like. Thus, the amounts of etching differed from those in Examples 1 and 2. In the other examples, if the amount of etching differed even though the experimental conditions were the same, it was because the experiments had been conducted on different days or the like.

Comparative Example 2 was the same as Example 6, except that the first voltage was set to -2V. In Comparative Example 2, the potential on the side wall surfaces 942 of the microstructures 94 was switched between -8V and -2V in the voltage switching cycle of six seconds. In Comparative Example 2, the amount of etching was 11 nm, approximately as in Comparative Example 1 (see Table 1).

A comparison between Examples 6 to 10 and Comparative Example 2 shows that, if the first potential and the second potential on the side wall surfaces 942 were both negative (i.e., had the same sign) in step S14 (at the time of switching of the applied voltage) (Comparative Example 2), there was no increase in the etch rate of the processing membrane 96 within the recessed portion 95. On the other hand, in the case where the first potential and the second potential on the side wall surfaces 942 did not have the same sign, even if the absolute value of the first potential was different from the absolute value of the second potential (Examples 6 to 8), the etch rate of the processing membrane 96 within the recessed portion 95 was increased in approximately the same manner as in the case where the first potential and the second potential had the same absolute value (Examples 9 and 10).

Note that Comparative Example 2 was merely a comparative example of the etching of the processing membrane 96 within the recessed portion 95, and it was confirmed that, for the processing membrane 96 on the end faces 941 (see Fig. 4) of the microstructures 94 (i.e., the processing membrane 96 outside the recessed portion 95), the etch rate was increased by applying a voltage as described above as compared with Comparative Example 1 in which no voltage was applied.

In Examples 11 to 14 shown in Table 3, the amount of etching of the processing membrane 96 was measured by changing the voltage switching cycle of the applied voltage in step S14. In Example 11, the voltage applied from the power source 975 was a direct voltage, the second voltage was set to -1V, and the first voltage was set to +1V. The voltage switching cycle of the applied voltage was two seconds. That is, in Example 11, the potential on the side wall surfaces 942 of the microstructures 94 (i.e., the inner surface of the recessed portion 95) was switched between the second potential of -1V and the first potential of +1V in the voltage switching cycle of two seconds. In Example 11, the amount of etching was 20.5 nm.

Example 12 was the same as Example 11, except that the voltage switching cycle was set to six seconds. In Example 12, the potential on the side wall surfaces 942 of the microstructures 94 was switched between the second potential of -1V and the first potential of +1V in the voltage switching cycle of six seconds. In Example 12, the amount of etching was 21.5 nm.

Example 13 was the same as Example 11, except that the voltage switching cycle was set to 12 seconds. In Example 13, the potential on the side wall surfaces 942 of the microstructures 94 was switched between the second potential of -1V and the first potential of +1V in the voltage switching cycle of 12 seconds. In Example 13, the amount of etching was 22 nm.

Example 14 was the same as Example 11, except that the voltage switching cycle was set to 18 seconds. In Example 14, the potential on the side wall surfaces 942 of the microstructures 94 was switched between the second potential of -1V and the first potential of +1V in the voltage switching cycle of 18 seconds. In Example 14, the amount of etching was 19.5 nm.

In Comparative Example 1, the application of the voltage in step S14 was omitted as described above. In Comparative Example 1, the amount of etching was 11 nm as described above.

A comparison between Examples 11 to 14 and Comparative Example 1 shows that, even if the voltage switching cycle differed, the etch rate of the processing membrane 96 within the recessed portion 95 was increased by performing step S14 (the switching of the applied voltage).

In Examples 15 to 17 shown in Table 4, the amount of etching of the processing membrane 96 was measured by using an alternating voltage as the applied voltage in step S14 and changing the frequency of the alternating voltage (i.e., changing the voltage switching cycle). In Example 15, the voltage applied from the power source 975 was an alternating voltage, the second voltage was set to -1V, and the first voltage was set to +1V. The frequency of the applied voltage was 0.5 Hz (i.e., the voltage switching cycle was two seconds). That is, in Example 15, the potential on the side wall surfaces 942 of the microstructures 94 (i.e., the inner surface of the recessed portion 95) was switched between the second potential of -1V and the first potential of +1V in the voltage switching cycle of two seconds. In Example 15, the amount of etching was 21 nm.

Example 16 was the same as Example 15, except that the frequency was set to 1 Hz (the voltage switching cycle was set to one seconds). In Example 16, the potential on the side wall surfaces 942 of the microstructures 94 was switched between the second potential of -1V and the first potential of +1V in the voltage switching cycle of one seconds. In Example 16, the amount of etching was 22 nm.

Example 17 was the same as Example 15, except that the frequency was set to 5 Hz (the voltage switching cycle was set to 0.2 seconds). In Example 17, the potential on the side wall surfaces 942 of the microstructures 94 was switched between the second potential of -1V and the first potential of +1V in the voltage switching cycle of 0.2 seconds. In Example 17, the amount of etching was 16.5 nm.

In Comparative Example 1, the application of the voltage in step S14 was omitted as described above. In Comparative Example 1, the amount of etching was 11 nm as described above.

A comparison between Examples 15 to 17 and Comparative Example 1 shows that, even if the frequency of the alternating voltage differed (i.e., the voltage switching cycle differed), the etch rate of the processing membrane 96 within the recessed portion 95 was increased by performing step S14 (the switching of the applied voltage). A comparison between Examples 15 and 11 (Table 3) also shows that, if the same first voltage, the same second voltage, and the same voltage switching cycle were used, the etch rate became approximately the same, irrespective of whether the applied voltage was a direct voltage or an alternating voltage.

In Examples 18 to 28 and Comparative Example 3 shown in Tables 5 to 7, hydrogen peroxide water was used as the processing liquid as described above. In Examples 18 to 22 shown in Table 5, the amount of etching of the processing membrane 96 was measured by changing the first and second voltages used as the applied voltage in step S14. In Example 18, the voltage applied from the power source 975 was a direct voltage, the second voltage was set to -1V, and the first voltage was set to +1V. The voltage switching cycle of the applied voltage was two seconds. That is, in Example 18, the potential on the side wall surfaces 942 of the microstructures 94 (i.e., the inner surface of the recessed portion 95) was switched between the second potential of -1V and the first potential of +1V in the voltage switching cycle of two seconds. In Example 18, the amount of etching was 18 nm.

Example 19 was the same as Example 18, except that the second voltage was set to -2V, and the first voltage was set to +2V. In Example 19, the potential on the side wall surfaces 942 of the microstructures 94 was switched between the second potential of -2V and the first potential of +2V in the voltage switching cycle of two seconds. In Example 19, the amount of etching was 18.5 nm.

Example 20 was the same as Example 18, except that the second voltage was set to -3V, and the first voltage was set to +3V. In Example 20, the potential on the side wall surfaces 942 of the microstructures 94 was switched between the second potential of -3V and the first potential of +3V in the voltage switching cycle of two seconds. In Example 20, the amount of etching was 19 nm.

Example 21 was the same as Example 18, except that the second voltage was set to -5V and the first voltage was set to +5V. In Example 21, the potential on the side wall surfaces 942 of the microstructures 94 was switched between the second potential of -5V and the first potential of +5V in the voltage switching cycle of two seconds. In Example 21, the amount of etching was 22.5 nm.

Example 22 was the same as Example 18, except that the second voltage was set to -8V, and the first voltage was set to +8V. In Example 22, the potential on the side wall surfaces 942 of the microstructures 94 was switched between the second potential of -8V and the first potential of +8V in the voltage switching cycle of two seconds. In Example 22, the amount of etching was 24.5 nm.

In Comparative Example 3, the application of the voltage in step S14 was omitted as described above. In Comparative Example 3, the amount of etching was 15.5 nm.

A comparison between Examples 18 to 22 and Comparative Example 3 shows that, even if the applied voltage differed, the etch rate of the processing membrane 96 within the recessed portion 95 was increased by performing step S14 (the switching of the applied voltage).

In Examples 23 to 25 shown in Table 6, the amount of etching of the processing membrane 96 was measured by changing the voltage switching cycle of the applied voltage in step S14. In Example 23, the voltage applied from the power source 975 was a direct voltage, the second voltage was set to -5V, and the first voltage was set to +5V. The voltage switching cycle of the applied voltage was 0.5 seconds. That is, in Example 23, the potential on the side wall surfaces 942 of the microstructures 94 (i.e., the inner surface of the recessed portion 95) was switched between the second potential of -5V and the first potential of +5V in the voltage switching cycle of 0.5 seconds. In Example 23, the amount of etching was 19 nm.

Example 24 was the same as Example 23, except that the voltage switching cycle was set to one seconds. In Example 24, the potential on the side wall surfaces 942 of the microstructures 94 was switched between the second potential of -5V and the first potential of +5V in the voltage switching cycle of one seconds. In Example 24, the amount of etching was 21 nm.

Example 25 was the same as Example 23, except that the voltage switching cycle was set to two seconds. In Example 25, the potential on the side wall surfaces 942 of the microstructures 94 was switched between the second potential of -5V and the first potential of +5V in the voltage switching cycle of two seconds. In Example 25, the amount of etching was 20 nm.

In Comparative Example 3, the application of the voltage in step S14 was omitted as described above. In Comparative Example 3, the amount of etching was 15.5 nm as described above.

A comparison between Examples 23 to 25 and Comparative Example 3 shows that, even if the voltage switching cycle differed, the etch rate of the processing membrane 96 within the recessed portion 95 was increased by performing step S14 (the switching of the applied voltage).

In Examples 26 to 28 shown in Table 7, the amount of etching of the processing membrane 96 was measured by using an alternating voltage as the applied voltage in step S14 and changing the frequency of the alternating voltage (i.e., changing the voltage switching cycle). In Example 26, the voltage applied from the power source 975 was an alternating voltage, the second voltage was set to -5V, and the first voltage was set to +5V. The frequency of the applied voltage was 1 Hz (i.e., the voltage switching cycle was one seconds). That is, in Example 26, the potential on the side wall surfaces 942 of the microstructures 94 (i.e., the inner surface of the recessed portion 95) was switched between the second potential of -5V and the first potential of +5V in the voltage switching cycle of one seconds. In Example 26, the amount of etching was 20.5 nm.

Example 27 was the same as Example 26, except that the frequency was set to 10 Hz (the voltage switching cycle was set to 0.1 seconds). In Example 27, the potential on the side wall surfaces 942 of the microstructures 94 was switched between the second potential of -5V and the first potential of +5V in the voltage switching cycle of 0.1 seconds. In Example 27, the amount of etching was 26 nm.

Example 28 was the same as Example 26, except that the frequency was set to 20 Hz (the voltage switching cycle was set to 0.05 seconds). In Example 28, the potential on the side wall surfaces 942 of the microstructures 94 was switched between the second potential of -5V and the first potential of +5V in the voltage switching cycle of 0.05 seconds. In Example 28, the amount of etching was 17.5 nm.

In Comparative Example 3, the application of the voltage in step S14 was omitted as described above. In Comparative Example 3, the amount of etching was 15.5 nm as described above.

A comparison between Examples 26 to 28 and Comparative Example 3 shows that, even if the frequency of the alternating voltage differed (i.e., the voltage switching cycle differed), the etch rate of the processing membrane 96 within the recessed portion 95 was increased by performing step S14 (the voltage switching of the applied voltage). A comparison between Examples 26 and 24 (Table 6) also shows that, if the same first voltage, the same second voltage, and the same voltage switching cycle were used, the etch rate became approximately the same, irrespective of whether the applied voltage was a direct voltage or an alternating voltage.

As described thus far, the substrate processing apparatus 1 includes the substrate holder 21, the substrate rotation mechanism 23, the nozzle 51, the nozzle movement mechanism 55, the first electrode 61, the second electrode 62, the power source 63, and the controller 8. The substrate holder 21 holds a substrate 9 in a horizontal position, the substrate having the upper surface 91 on which the processing membrane 96 is provided. The substrate rotation mechanism 23 rotates the substrate holder 21 about the central axis J1 extending in the up-down direction. The nozzle 51 supplies a processing liquid for etching to the upper surface 91 of the substrate 9 to bring the processing liquid into contact with the processing membrane 96. The nozzle movement mechanism 55 causes the nozzle 51 to rock horizontally above the rotating substrate 9 and between the central portion and the peripheral edge portion of the substrate 9.

The first electrode 61 is electrically connected to the substrate 9. The second electrode 62 is electrically connected to the processing liquid ejected from the nozzle 51. The power source 63 applies a voltage between the first electrode 61 and the second electrode 62. The controller 8 controls the substrate rotation mechanism 23, the nozzle 51, and the power source 63. Under the control of the controller 8, the processing liquid is continuously supplied from the nozzle 51 that is rocking above the rotating substrate 9 toward the upper surface 91 of the substrate 9, and while the voltage is applied between the first electrode 61 and the second electrode 62, the rotational frequency of the substrate 9 is repeatedly switched between the first rotational frequency and the second rotational frequency different from the first rotational frequency in a predetermined rotational-frequency switching cycle.

As described above, the substrate processing apparatus 1 is capable of increasing the etch rate of the processing membrane 96 within the recessed portion 95 by switching the rotational frequency of the substrate 9 so as to produce a flow of the processing liquid within the recessed portion 95 of the substrate 9. Then, in this state, a voltage is applied between the substrate 9 and the processing liquid. This further increases the etch rate of the processing membrane 96.

As described above, the rotational-frequency switching cycle is preferably an integral multiple of the voltage switching cycle. Accordingly, a predetermined number of times of voltage switching are performed during the time when the acceleration and deceleration of the rotational frequency of the substrate 9 are each performed once. As a result, it is possible to favorably increase the etch rate of the processing membrane 96.

More preferably, the rotational-frequency switching cycle is an even multiple of the voltage switching cycle. In this case, the switching of the applied voltage from the first voltage to the second voltage and the switching of the applied voltage from the second voltage to the first voltage are each performed once or more during the time between the start of acceleration of the rotational frequency of the substrate 9 and the start of deceleration thereof. The switching of the applied voltage from the first voltage to the second voltage and the switching of the applied voltage from the second voltage to the first voltage are also each performed once or more during the time between the start of deceleration of the rotational frequency of the substrate 9 to the start of acceleration thereof. As a result, it is possible to further increase the etch rate of the processing membrane 96.

As described above, the switching of the rotational frequency of the substrate 9 is performed simultaneously with the switching of the applied voltage under the control of the controller 8. This makes it possible to favorably increase the etch rate of the processing membrane 96.

As described above, in the substrate processing apparatus 1, under the control of the controller 8, the applied voltage is repeatedly switched between the first voltage and the second voltage different from the first voltage in a predetermined voltage switching cycle, in parallel with the switching of the rotational frequency of the substrate 9. Accordingly, the potential on the side wall surfaces 942, which form the recessed portion 95 in the patten 93 on the substrate 9, is repeatedly switched between the first potential and the second potential lower than the first potential. The first potential is higher than or equal to 0V, and the second potential is lower than or equal to 0V. This increases the etch rate of the processing membrane 96 located within the recessed portion 95 as illustrated in Examples 1 to 28. The reason for the increase in the etch rate can, for example, be considered as follows.

According to the above-described first principle, water molecules or the like adsorbing onto the surface of the processing membrane 96 within the recessed portion 95 can favorably be electrolyzed by repeatedly switching the potential on the side wall surfaces 942. This allows an etchant such as hydrogen peroxide to favorably adsorb onto the processing membrane 96. As a result, it is possible to increase the etch rate of the processing membrane 96.

According to the above-described second principle, product that have been generated by etching and increased in number in the recessed portion 95 (hereinafter, also referred to as "etching products") can favorably be discharged to the outside of the recessed portion 95 by repeatedly switching the potential on the side wall surfaces 942. As a result, the etchant can easily enter the recessed portion 95. This increases the etch rate of the processing membrane 96.

According to the above-described third principle, air bubbles that have formed in the recessed portion 95 can favorably be discharged to the outside of the recessed portion 95 by repeatedly switching the potential on the side wall surfaces 942. As a result, an etchant can easily enter the recessed portion 95. This increases the etch rate of the processing membrane 96.

According to the above-described fourth principle, complexes that have been produced by etching and increased in number within the recessed portion 95 can favorably be discharged to the outside of the recessed portion 95 by repeatedly switching the potential on the side wall surfaces 942. As a result, an etchant can easily enter the recessed portion 95. This increases the etch rate of the processing membrane 96.

As described above, the voltage switching cycle of the applied voltage is preferably more than or equal to 0.05 seconds. This further increases the etch rate of the processing membrane 96 located within the recessed portion 95. The reason for the further increase in the etch rate can, for example, be considered as follows.

According to the above-described first principle, if the voltage switching cycle is less than 0.05 seconds, the applied voltage may be switched before water molecules or the like adsorbing on the surface of the processing membrane 96 are fully electrolyzed sufficiently, and accordingly the electrolysis of the water molecules or the like may become insufficient. This incurs the risk of inhibiting the adsorption of the etchant onto the processing membrane 96 due to the presence of water molecules or the like and resulting in an insufficient increase in the etch rate. On the other hand, if the voltage switching cycle is more than or equal to 0.05 seconds, the electrolysis of water molecules or the like can favorably be conducted, which further increases the etch rate of the processing membrane 96.

According to the above-described second principle, if the voltage switching cycle is less than 0.05 seconds, the applied voltage may be switched before the etching products are fully discharged to the outside of the recessed portion 95, and accordingly the discharge of the etching products to the outside of the recessed portion 95 may become insufficient. This incurs the risk of inhibiting the entry of the etchant into the recessed portion 95 and resulting in an insufficient increase in the etch rate. On the other hand, if the voltage switching cycle is more than or equal to 0.05 seconds, the etching products can favorably be discharged to the outside of the recessed portion 95, which further increases the etch rate of the processing membrane 96.

According to the above-described third principle, if the voltage switching cycle is less than 0.05 seconds, the applied voltage may be switched before air bubbles are fully discharged to the outside of the recessed portion 95, and accordingly the discharge of air bubbles to the outside of the recessed portion 95 may become insufficient. This incurs the risk of inhibiting the entry of the etchant into the recessed portion 95 and resulting in an insufficient increase in the etch rate. On the other hand, if the voltage switching cycle is more than or equal to 0.05 seconds, air bubbles can favorably be discharged to the outside of the recessed portion 95, which further increases the etch rate of the processing membrane 96.

According to the above-described fourth principle, if the voltage switching cycle is less than 0.05 seconds, the applied voltage may be switched before complexes are fully discharged to the outside of the recessed portion 95, and accordingly the discharge of the complexes to the outside of the recessed portion 95 may become insufficient. This incurs the risk of inhibiting the entry of the etchant into the recessed portion 95 and resulting in an insufficient increase in the etch rate. On the other hand, if the voltage switching cycle is more than or equal to 0.05 seconds, the complexes can favorably be discharged to the outside of the recessed portion 95, which further increases the etch rate of the processing membrane 96.

As described above, in the case where the applied voltage is a direct voltage, the voltage switching cycle is preferably more than or equal to 0.5 seconds. This allows a favorable increase in the etch rate of the processing membrane 96.

As described above, in the case where the applied voltage is an alternating voltage, the voltage switching cycle is preferably more than or equal to 0.2 seconds. This allows a favorable increase in the etch rate of the processing membrane 96.

The substrate processing method described above includes the step of holding a substrate 9 in a horizontal position, the substrate having the upper surface 91 on which the processing membrane 96 is provided (step S11), the step of continuously supplying a processing liquid for etching from the nozzle 51 toward the upper surface 91 of the substrate 9, the nozzle 51 rocking between the central portion and the peripheral edge portion of the substrate 9 above the substrate 9 that is rotating about the central axis J1 extending in the up-down direction (step S12), the step of, in parallel with step S12, switching the rotational frequency of the substrate 9 between the first rotational frequency and the second rotational frequency different from the first rotational frequency in a predetermined rotational-frequency switching cycle (step S13), and the step of, in parallel with step S13, applying a voltage between the substate 9 and the processing liquid ejected from the nozzle 51 and repeatedly switching the applied voltage between the first voltage and the second voltage different from the first voltage in a predetermined voltage switching cycle so that the potential on the side wall surfaces 942, which form the recessed portion 95 in the patten 93 (i.e., the fine pattern 93) on the substrate 9, is repeatedly switched between the first potential and the second potential lower than the first potential (step S14). The first potential is higher than or equal to 0V, and the second potential is lower than or equal to 0V. This increases the etch rate of the processing membrane 96 located within the recessed portion 95 as described above.

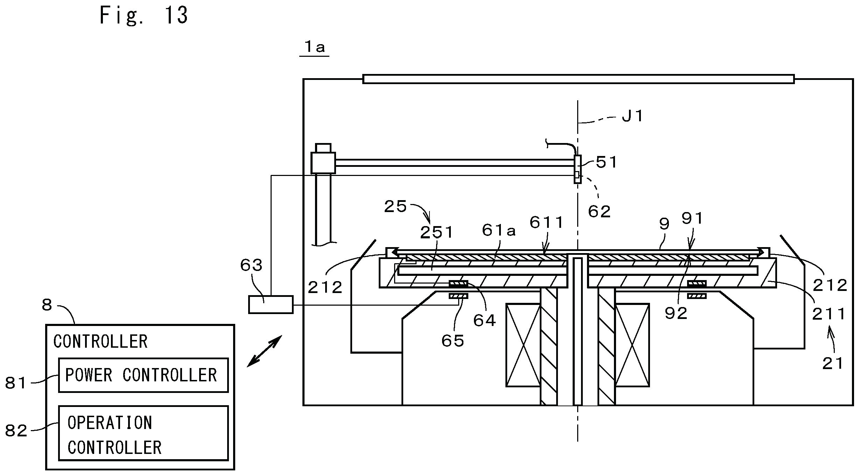

The configuration of the substrate processing apparatus 1 is not limited to the examples described above, and may be modified in various ways. For example, a substrate processing apparatus 1a shown in Fig. 13 includes a first electrode 61a arranged in the upper surface of the base part 211 of the substrate holder 21, instead of the multiple first electrodes 61 provided on the multiple chuck points 212 (see Fig. 2). The first electrode 61a is an approximately annular plate-like or disc-like conductive member centered on the central axis J1. Just as with the first electrodes 61 described above, the first electrode 61a is formed of, for example, platinum (Pt) or glassy carbon (GC). In plan view, for example, the outside diameter of the first electrode 61a is slightly smaller than the diameter of the substrate 9. Note that the outside diameter of the first electrode 61a may be greater than or approximately the same as the diameter of the substrate 9 in plan view. Just as with the multiple first electrodes 61 described above, the first electrode 61a is electrically connected to the power source 66 via the first transmitter 64 and the second transmitter 65. Note that the shape, material, or the like of the first electrode 61a may be changed in various ways.

An upper surface 611 of the first electrode 61a is not covered with the base part 211 and is exposed from the upper surface of the base part 211. The upper surface 611 of the first electrode 61a extends approximately across the entire lower surface 92 of the substrate 9 and faces the lower surface 92 in direct face-to-face contact in the up-down direction. Thus, the first electrode 61a is electrically connected to the substrate 9. In the substrate processing apparatus 1a, the upper surface 611 of the first electrode 61a faces the nozzle 51 where the second electrode 62 is provided, with the substrate 9 sandwiched therebetween, irrespective of the position of the rocking nozzle 51.

In the substrate processing apparatus 1a, the first electrode 61a is provided over a relatively wide range in face-to-face contact with the lower surface 92 of the substrate 9. This alleviates the concentration of current on the peripheral edge portion of the substrate 9 during the etching in step S14, as compared with the case of the substrate processing apparatus 1 in which the first electrodes 61 are electrically connected to only the peripheral edge portion of the substrate 9. This suppresses variations in the potential on the processing membrane 96 (see Fig. 4) depending on the position in the radial direction on the substrate 9. The first electrode 61a also comes into direct contact with the substrate 9 along the entire circumference centered on the central axis J1. This also suppresses variation in the potential on the processing membrane 96 depending on the position in the circumferential direction on the substrate 9 (e.g., in the case of the substrate processing apparatus 1, the angle formed between the chuck pins 21 in the circumferential direction). As a result, it is possible to improve uniformity in the etch rate of the substrate 9 in both the radial direction and the circumferential direction.

In the substrate processing apparatus 1a, the first electrode 61a may be movable relative to the base part 211 in the up-down direction. In this case, when the substrate 9 is transported into the substrate processing apparatus 1a and held by the substrate holder 21, the first electrode 61a may be spaced below from the substrate 9, and after the substrate 9 is held by the multiple chuck pins 212, the first electrode 61a may be moved up relative to the base part 211 to come into direct contact with the lower surface 92 of the substrate 9. A mechanism for moving the first electrode 61a relative to the base part 211 in the up-down direction may, for example, be an electric linear motor, an air cylinder, or a combination of a ball screw and an electric rotary motor, any of which is connected to the first electrode 61a.

As described above, the substrate processing apparatus 1a includes the first electrode 61a that is provided in the upper surface of the base part 211 and comes in face-to-face contact with the lower surface 92 of the substrate 9. This further improves uniformity in the etch rate of the substrate 9.

Note that the substrate processing apparatus 1a may include the multiple first electrodes 61 (see Fig. 2) arranged respectively on the upper inner side faces 213 of the multiple chuck pins 212, in addition to the first electrode 61a described above. In this case, just as with the first electrode 61a, the multiple first electrodes 61 are electrically connected to the power source 63 via the first transmitter 64 and the second transmitter 65. During the etching in step S14, the multiple first electrodes 61 are set to the same potential as the first electrode 61a by applying a voltage from the power source 66.

As shown in Fig. 13, the substrate processing apparatus 1a may include a heater 25 that heats the substrate 9 from the underside. The heater 25 includes a hot plate 251 arranged inside the base part 211 of the substrate holder 21. The hot plate 251 is arranged below the first electrode 61a provided in the upper surface of the base part 211. In other words, the first electrode 61a is arranged between the hot plate 251 built in the base part 211 and the lower surface 92 of the substrate 9.

The hot plate 251 is an approximately annular plate-like or disc-like member centered on the central axis J1. For example, the outside diameter of the hot plate 251 is slightly smaller than the diameter of the substrate 9. The hot plate 251 is an electric heater with heating wires (not shown) embedded in the interior of a hot-plate body. The hot plate body formed of ceramics or the like is increased in temperature by supplying electric power to the heating wires.

In the substrate processing apparatus 1a, during the etching in step S14, the hot plate 251 arranged below the first electrode 61a comes into indirect contact with the lower surface 92 of the substrate 9 via the first electrode 61a. The substrate 9 is heated from the underside by the hot plate 251 via the first electrode 61a. The first electrode 61a is preferably formed of a material with relatively high thermal conductivity, such as glassy carbon.

In the substrate processing apparatus 1a, the temperature of the processing membrane 96 (see Fig. 4) is increased as a result of the substrate 9 being heated by the heater 25. This increases the etch rate of the processing membrane 96. Since the electric resistance of the substrate 9 decreases with increasing temperature, the applied voltage required to accelerate the etching can be lowered by heating the substrate 9. During the etching in step S14, the temperature of the upper surface 91 of the substrate 9 is preferably set in the range of, for example, 40°C to 100°C.

In the substrate processing apparatus 1a, the operation controller 82 may control the heater 25 so that the temperature of the hot plate 251 is changed depending on the position in the radial direction. In other words, as a result of the heater 25 being controlled by the operation controller 82, the amount of heat applied per unit area of the lower surface 92 of the substrate 9 from the hot plate 251 can be changed depending on the distance in the radial direction from the central axis J1 on the substrate 9.

Specifically, for example, the hot plate body of the hot plate 251 includes a plurality of heating wires arranged approximately concentrically about the central axis J1. Electric power supplied to these heating wires can be controlled independently. By adjusting the electric power supplied to each of the multiple heating wires of the hot plate 251, the temperature of the hot plate 251 can be adjusted for each position in the radial direction. Accordingly, the amount of heat applied per unit area of the lower surface 92 of the substrate 9 from the hot plate 251 can be adjusted for each position in the radial direction.

In the substrate processing apparatus 1a, for example, if the etch rate of the peripheral edge portion of the substrate 9 becomes lower than the etch rate of the central portion of the substrate 9 as a result of uniform heating of the substrate 9, the heater 25 is controlled such that the temperature on the peripheral edge portion of the hot plate 251 becomes higher than the temperature on the central position of the hot plate 251. This improves uniformity in the etch rate of the substrate 9 in the radial direction.

As described above, the substrate processing apparatus 1a further includes the heater 25 that heats the substrate 9 from the underside. Therefore, the etch rate of the processing membrane 96 can be increased by increasing the temperature of the substrate 9.

As described above, the heater 25 is preferably capable of changing the amount of heat applied per unit area of the lower surface 92 of the substrate 9 depending on the distance from the center of the substrate 9 (i.e., the central axis J1). This improves uniformity in the etch rate of the substrate 9 in the radial direction.

The substrate processing apparatuses 1 and 1a described above may be modified in various ways.

For example, in steps S13 and S14, the switching of the rotational frequency of the substrate 9 (i.e., the start of acceleration or deceleration of the rotational frequency of the substrate 9) does not necessarily have to be performed simultaneously with the switching of the applied voltage, and may be performed with timing different from the timing of switching of the applied voltage.

The rotational-frequency switching cycle of the substrate 9 does not necessarily have to be an even multiple of the voltage switching cycle of the applied voltage, and may also be an odd multiple of the voltage switching cycle of the applied voltage. As another alternative, the rotational-frequency switching cycle does not necessarily have to be an integral multiple of the voltage switching cycle. As described above, the rotational-frequency switching cycle may be shorter than the voltage switching cycle.

Just as with the substrate processing apparatus 1a, the substrate processing apparatus 1 may also include the hot plate 251 that is built in the base part 211 of the substrate holder 21. In the substrate processing apparatus 1, the first electrodes 61 are provided on the chuck pins 212 as described above, which offers a high degree of flexibility in the design of the base part 211. Therefore, the heater 25 can be arranged favorably. As another alternative, the hot plate 251 may be provided between the upper surface of the base part 211 and the lower surface 92 of the substrate 9 so as to directly face the lower surface 92 of the substrate 9 in the up-down direction (i.e., without any intervention of other members). In this case, a hot-plate movement mechanism for moving the hot plate 251 in the up-down direction may be provided in order to change the distance between the hot plate 251 and the lower surface 92 of the substrate 9.

In the substrate processing apparatuses 1 and 1a, the shape, arrangement, and so on of the hot plate 251 are not limited to the examples described above, and may be changed in various ways. For example, the outside diameter of the hot plate 251 may be slightly greater than or approximately the same as the diameter of the substrate 9. The heater 25 that heats the substrate 9 does not necessarily have to include the hot plate 251, and the structure of the heater 25 may be modified in various ways. For example, the heater 25 may include, instead of the hot plate 251, a lamp that heats the substrate 9 by irradiating the lower surface 92 of the substrate 9 with light.

In the rinse processing performed in step S15 in the substrate processing apparatus 1, the rinsing liquid may be supplied from a different nozzle other than the nozzle 51 to the upper surface 91 of the substrate 9. The same also applies to the substrate processing apparatus 1a.

In the substrate processing apparatus 1, the electrical connection between the first electrode 61 and the power source 63 does not necessarily have to be established without physical contact. For example, the first electrode 61 and the power source 63 may be mechanically and electrically connected to each other via a slip ring or the like provided on the shaft 217. The same also applies to the first electrode 61a of the substrate processing apparatus 1a. In this case, the first transmitter 64 and the second transmitter 65 may be omitted.

In the substrate processing apparatus 1, the aforementioned voltage switching cycle of the applied voltage may be less than 0.05 seconds. Moreover, the substrate processing apparatus 1 does not necessarily have to switch the applied voltage as described above, and the applied voltage may be always constant. Approximately the same also applies to the substrate processing apparatus 1a.

The substrate holder 21 does not necessarily have to be a mechanical chuck and may have any of other various structures. For example, the substrate holder 21 may be a vacuum chuck that adsorbs onto and holds the substrate 9 in direct face-to-face contact with the lower surface 92 of the substrate 9. In this case, for example, the upper surface of the vacuum chuck that comes into contact with the lower surface 92 of the substrate 9 may serve as an approximately disc-like first electrode, and the substrate 9 and the first electrode may be electrically connected to each other by the first electrode coming into direct face-to-face contact with the lower surface 92 of the substrate 9.

The substrate processing apparatuses 1 and 1a described above may be used to process not only semiconductor substrates, but also glass substrates that are used in flat panel displays such as liquid crystal displays or organic electro luminescence (EL) displays, or glass substrates that are used in other display devices. The substrate processing apparatuses 1 and 1a described above may also be used to process other substrates such as optical-disc substrates, magnetic-disc substrates, magneto-optical-disc substrates, photomask substrates, ceramic substrates, or substrates for solar cells.

The configurations according to the above-described embodiment and variations may appropriately be combined as long as there are no mutual inconsistencies.

While the invention has been shown and described in detail, the foregoing description is in all aspects illustrative and not restrictive. It is therefore understood that numerous modifications and variations can be devised without departing from the scope of the invention.

### REFERENCE SIGNS LIST

- 1, 1a: substrate processing apparatus
- 8: controller
- 9: substrate
- 21: substrate holder
- 23: substrate rotation mechanism
- 51: nozzle
- 55: nozzle movement mechanism
- 61, 61a: first electrode
- 62: second electrode
- 63: power source
- 91: upper surface (of the substrate)
- 93: patten
- 95: recessed portion
- 96: processing membrane
- 942: side wall surface
- J1: central axis
- S11 to S16: step

## Claims

1. A substrate processing apparatus (1) that performs etching on a substrate (9), the substrate processing apparatus (1) comprising:
a substrate holder (21) that holds a substrate (9) in a horizontal position, the substrate (9) having an upper surface (91) on which a processing membrane (96) is provided;
a substrate rotation mechanism (23) that rotates said substrate holder (21) about a central axis (J1) extending in an up-down direction;
a nozzle (51) that supplies a processing liquid for etching from above said substrate (9) to said upper surface (91) of said substrate (9) to bring said processing liquid into contact with said processing membrane (96);
a nozzle movement mechanism (55) that causes said nozzle (51) to horizontally rock between a central portion of said substrate (9) and a peripheral edge portion of said substrate (9) above said substrate (9) that is being rotated;
a first electrode (61) that is electrically connected to said substrate (9);
a second electrode (62) that is electrically connected to said processing liquid ejected from said nozzle (51);
a power source (63) that provides an applied voltage between said first electrode (61) and said second electrode (62); and
a controller (8) that controls said substrate rotation mechanism (23), said nozzle (51), and said power source (63),
wherein, under control of said controller (8), a rotational frequency of said substrate (9) is repeatedly switched between a first rotational frequency and a second rotational frequency different from said first rotational frequency in a predetermined rotational-frequency switching cycle while said processing liquid is continuously supplied from said nozzle (51) to said upper surface (91) of said substrate (9), said nozzle (51) rocking above said substate that is being rotated, and a voltage is applied between said first electrode (61) and said second electrode (62).

2. The substrate processing apparatus (1) according to claim 1, wherein
under control of said controller (8), in parallel with switching of the rotational frequency of said substrate (9), a potential on a side wall surface (942) that forms a recessed portion (95) in a pattern (93) on said substrate (9) is repeatedly switched between a first potential and a second potential lower than said first potential by repeatedly switching said applied voltage between a first voltage and a second voltage different from said first voltage in a predetermined voltage switching cycle,
said first potential is higher than or equal to 0V, and
said second potential is lower than or equal to 0V.

3. The substrate processing apparatus (1) according to claim 2, wherein
said predetermined voltage switching cycle is more than or equal to 0.05 seconds.

4. The substrate processing apparatus (1) according to claim 2 or 3, wherein
said predetermined rotational-frequency switching cycle is an integer multiple of said predetermined voltage switching cycle.

5. The substrate processing apparatus (1) according to claim 4, wherein
said predetermined rotational-frequency switching cycle is an even multiple of said predetermined voltage switching cycle.

6. The substrate processing apparatus (1) according to any one of claims 2 to 5, wherein
switching of the rotational frequency of said substrate (9) is performed simultaneously with switching of said applied voltage under control of said controller (8).

7. A substrate processing method of performing etching on a substrate (9), the substrate processing method comprising:
a) holding a substrate (9) in a horizontal position, the substrate (9) having an upper surface (91) on which a processing membrane (96) is provided;
b) continuously supplying a processing liquid for etching from a nozzle (51) to said upper surface (91) of said substrate (9), the nozzle (51) rocking horizontally between a central portion of said substrate (9) and a peripheral edge portion of said substrate (9) above said substrate (9) that is being rotated about a central axis (J1) extending in an up-down direction;
c) in parallel with said operation b), repeatedly switching a rotational frequency of said substrate (9) between a first rotational frequency and a second rotational frequency different from said first rotational frequency in a predetermined rotational-frequency switching cycle; and
d) in parallel with said operation c), providing an applied voltage between said substrate (9) and said processing liquid ejected from said nozzle (51) and repeatedly switching a potential on a side wall surface (942) between a first potential and a second potential lower than said first potential, the side wall surface (942) forming a recessed portion (95) in a pattern (93) on said substrate (9), by repeatedly switching said applied voltage between a first voltage and a second voltage different from said first voltage in a predetermined voltage switching cycle,
wherein said first potential is higher than or equal to 0V, and
said second potential is lower than or equal to 0V.
